# EUROPEAN PATENT APPLICATION

(11) **EP 3 121 210 A1**
(43) Date of publication of application: **25.01.2017**
(21) Application number: 15765417.9
(22) Date of filing: 19.03.2015
(51) Int. Cl.: C08G 59/38, B32B 27/38, C08J 5/18, C08K 3/38, C08L 63/00, H01L 23/36

(54) **RESIN COMPOSITION, RESIN SHEET, RESIN SHEET CURED PRODUCT, RESIN SHEET LAMINATE, RESIN SHEET LAMINATE CURED PRODUCT AND METHOD FOR PRODUCING SAME, SEMICONDUCTOR DEVICE, AND LED DEVICE.**

(30) Priority: 20.03.2014 JP 2014058833
(71) Applicant: Hitachi Chemical Co., Ltd., Chiyoda-ku Tokyo 100-6606 (JP)
(72) Inventor: NISHIYAMA, Tomoo, Tokyo 100-6606 (JP); HARA, Naoki, Tokyo 100-6606 (JP); YOSHIE, Shigemitsu, Tokyo 100-6606 (JP); KUWANO, Atsushi, Tokyo 100-6606 (JP)
(74) Representative: Hoffmann Eitle
(86) International application number: PCT/JP2015/058334
(87) International publication number: WO 2015/141797

(57) **Abstract**

A resin composition including: a trifunctional or higher-functional first epoxy resin having, in a molecule thereof, a structure including two naphthalene rings linked together by an alkylene chain; a bifunctional second epoxy resin having a mesogenic structure in a molecule thereof; and a curing agent.

## Description

### Technical Field

The present invention relates to a resin composition, a resin sheet, a resin sheet cured body, a resin sheet laminated body, a resin sheet laminated body cured product and a method of producing the same, a semiconductor instrument, and an LED instrument.

### Background Art

Along with the progress toward downsizing, capacity enlargement, performance improvement, and the like in electronic devices using semiconductors, the heat generation from semiconductors mounted at high density is increasing. For example, stable operation of central processing units of personal computers, semiconductor instruments used for controlling an electric car motor, or the like necessitates heat radiation by, for example, heat sinks, radiation fins, or the like. Therefore, there is a need for materials that achieve electrically insulating property as well as thermal conductivity and have high reliability even under high temperature operation environments, as members for connecting semiconductor instruments to heat sinks or the like.

In general, organic materials are widely used for electrically insulating materials in, for example, printed boards on which semiconductor instruments and the like are to be mounted. Although such organic materials have high electrically insulating property, thermal conductivity thereof is low. Therefore, the organic materials do not considerably contribute to radiation of heat from semiconductor instruments or the like. There are also cases in which inorganic materials, such as inorganic ceramics, are used for radiating heat from semiconductor instruments or the like. Such inorganic materials have high thermal conductivity. However, the inorganic materials do not provide sufficient connection reliability, compared to organic materials, due to the fact that semiconductor instruments or the like are joined to the inorganic materials, such as inorganic ceramics, via grease.

In connection with the above, various studies have been made on materials in which inorganic fillers having high thermal conductivity - referred to as fillers - are complexed with resins. For example, Japanese Patent Application Laid-Open (JP-A) No. 2001-055425 discloses an epoxy resin composition having a low melt viscosity and allowing incorporation of fillers at high content. Further, JP-A No. 2008-013759 discloses a cured material formed from a composite system of a common bisphenol A type epoxy resin and an alumina filler, and that the cured material can achieve a thermal conductivity coefficient of 3.8 W/mK as determined by a xenon flash method or 4.5 W/mK as determined by a temperature wave analysis. International Publication (WO) 2011/040416 similarly discloses a cured material formed from a composite system of a special epoxy resin, a novolac resin curing agent, and an alumina filler, and that the cured material can achieve a thermal conductivity coefficient of up to 9.8 W/mK. Further, International Publication (WO) 2012/133587 describes that it is possible to provide a resin sheet cured body having superior properties in all of thermal conductivity, adhesive strength, and electrically insulating property, as well as a resin sheet and a resin composition capable of forming the resin sheet cured body. It is described, in particular, that a resin sheet having excellent electrically insulating property under high temperature and high humidity can be provided.

### SUMMARY OF INVENTION

### Technical Problem

The resin cured material described in JP-ANo. 2001-055425 characteristically has a high glass transition temperature due to the use of a highly crosslinkable epoxy resin having dense reaction points and a phenol resin derived from dihydroxybenzene. However, the resin cured material has many reaction points, and it is conceivable that hydroxyl groups as by-products derived from epoxy groups provide a very high water absorption coefficient in the cured product, which may exert adverse effects on electrically insulating property and adhesion property.

It is conceivable that there are cases in which it is difficult for the resin cured material described in JP-A No. 2008-013759 to achieve both of high level thermal conductivity and high level adhesive strength to a member to which the resin composition is to be adhered. In particular, there is a tendency that use of a phenol compound as a curing agent increases the viscosity of the resin composition, as a result of which higher pressing pressure and higher temperature during curing are required for obtaining sufficient adhesive strength to the member to which the resin composition is to be attached. Further, it is conceivable that high thermal conductivity coefficient is not obtained due to the use of aluminum oxide.

In International Publication (WO) 2011/040416, a special epoxy resin monomer having a mesogenic structure is used. The resin characteristically has high thermal conductivity coefficient by itself due to the mesogen structure self-aligning during flowing period or curing period after melting of the resin. This resin has varying degrees of alignment depending on flow state, curing temperature, and the morphology and place at the time of shaping, and, therefore, the thermal conductivity coefficient of the resin tends to vary. Further, the proportion of mesogenic portions in the resin skeleton needs to be high. Therefore, the resin has a low crosslinking density, which prevents the glass transition temperature from becoming high even though the monomer has a high melting point. Accordingly, it is expected that the adhesive strength decreases at high temperatures.

It is described that the resin cured material described in International Publication (WO) 2012/133587 has excellent thermal conductivity and excellent shear adhesive strength at or around room temperature. However, boron nitride, having a low strength, is contained at high content in the resin composition, and a liquid epoxy resin needs to be added in order to achieve the B-stage, and the patent document includes no description about glass transition temperature. For reasons such as those listed above, it is expected that the resin cured material has a decreased adhesive strength at temperatures of 100°C or higher, which is the practical use temperature.

It is conceivable that the problems associated with the techniques disclosed in JP-A No. 2001-055425, JP-ANo. 2008-013759, International Publication (WO) 2011/040416, and International Publication (WO) 2012/133587 include the following problems. Specifically, the use of the epoxy resin containing a mesogenic structure, the novolac resin, and the like causes problems in handling due to high viscosity before curing, tends to provide insufficient adhesive strength, and, in some cases, has low wettability to the member to which the resin is to be adhered. Further, the orientating property tends to vary with the curing temperature, which makes it difficult to obtain a constant thermal conductivity coefficient in some cases. After curing, the low glass temperature unfavorably decreases the adhesive strength at high temperatures and the thermal conductivity coefficient in some cases. Further, the use of the epoxy resin capable of increasing the crosslinking density unfavorably results in a higher water absorption coefficient and a thermal conductivity coefficient that is not increased to a degree achievable with the epoxy resin having a mesogenic structure, although a higher glass transition temperature is obtained and the post-curing properties do not tend to deteriorate.

An object of an embodiment of the present invention is to provide: a resin composition that is flexible and has high handleability before curing, and that has excellent adhesive property at high temperature and excellent thermal conductivity after curing; and a resin sheet, a resin sheet cured body, a resin sheet laminated body, a resin sheet laminated body cured product and a method of producing the same, a semiconductor instrument, and an light emitting diode (LED) device, each of which uses the resin composition.

### Solution to Problem

Specific means for achieving the above object include the following.
<1> A resin composition including:
   a trifunctional or higher-functional first epoxy resin having, in a molecule thereof, a structure including two naphthalene rings linked together by an alkylene chain;
   a bifunctional second epoxy resin having a mesogenic structure in a molecule thereof; and
   a curing agent.
<2> The resin composition according to <1>, wherein the first epoxy resin includes a compound represented by the following Formula (I): 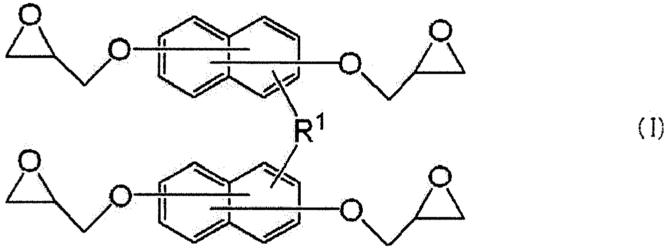 wherein, in Formula (I), R¹ represents an alkylene group having from 1 to 7 carbon atoms.
<3> The resin composition according to <1> or <2>, wherein the second epoxy resin includes at least one selected from the group consisting of a compound represented by the following Formula (II) and a compound represented by the following Formula (III): 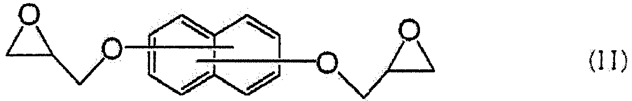 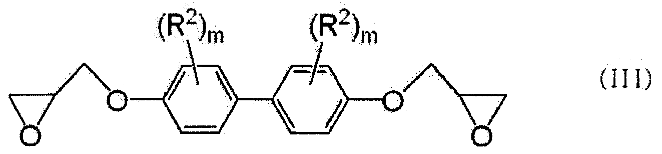 wherein, in Formula (III), each R² independently represents an alkyl group, an aryl group, or an aralkyl group, and each m independently represents an integer from 0 to 2.
<4> The resin composition according to any one of <1> to <3>, wherein a content ratio by mass of the first epoxy resin to the second epoxy resin (first epoxy resin : second epoxy resin) is from 25:75 to 85:15.
<5> The resin composition according to any one of <1> to <4>, wherein the curing agent includes a novolac resin including a structural unit represented by the following Formula (IV): 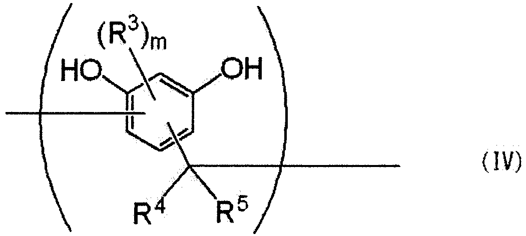 wherein, in Formula (IV), each R³ independently represents an alkyl group, an aryl group, or an aralkyl group, each of R⁴ and R⁵ independently represents a hydrogen atom, an alkyl group, an aryl group, or an aralkyl group, and m represents an integer from 0 to 2.
<6> The resin composition according to any one of <1> to <5>, further including, as fillers, boron nitride particles having a volume average particle diameter of from 20 µm to 80 µm and inorganic particles having a volume average particle diameter of 1 µm or less.
<7> A resin sheet including the resin composition of any one of <1> to <6>, the resin sheet having an average thickness of from 40 µm to 250 µm.
<8> The resin sheet according to <7>, wherein the resin sheet is bendable along an outer circumferential face of a circular cylinder having a diameter of 10 mm when the resin sheet is in a B-stage state.
<9> The resin sheet according to <7> or <8>, wherein the resin sheet includes a first resin layer including the resin composition of any one of <1> to <6>, and a second resin layer including the resin composition of any one of <1> to <6>, the second resin layer being layered on the first resin layer.
<10> The resin sheet according to any one of <7> to <9>, further including a metal foil on one face, and a plastic film on an opposite face from the face having the metal foil.
<11> A resin sheet cured body that is a heat-treated product of the resin sheet of any one of <7> to <10>.
<12> A resin sheet laminated body including the resin sheet of any one of <7> to <9>, and a metal plate or a heat radiation plate disposed on at least one face of the resin sheet.
<13> The resin sheet laminated body according to <12>, further including a member attached to an opposite face of the resin sheet from the face at which the metal plate or heat radiation plate is disposed.
<14> A resin sheet laminated body cured product that is a heat-treated product of the resin sheet laminated body of <12> or <13>.
<15> A method of producing a resin sheet laminated body cured product, the method including:
   a process of providing a metal plate or a heat radiation plate on at least one face of the resin sheet of any one of <7> to <9>, and
   a process of applying heat to the resin sheet, thereby curing the resin sheet.
<16> A semiconductor instrument including:
   a semiconductor device, and
   the resin sheet cured body of <11> disposed on the semiconductor device.
<17> An LED instrument including an LED device, the resin sheet cured body of <11>, and a substrate, which are stacked in this order.

### Advantageous Effects of Invention

According to an embodiment of the invention, a resin composition that is flexible and has high handleability before curing, and that has excellent adhesive property at high temperature and excellent thermal conductivity after curing, and a resin sheet, a resin sheet cured body, a resin sheet laminated body, a resin sheet laminated body cured product and a method of producing the same, a semiconductor instrument, and an LED instrument, each of which uses the resin composition, are provided.

### BRIEF DESCRIPTION OF DRAWINGS

Fig. 1 is a schematic cross-sectional view illustrating an example of a configuration of a power semiconductor instrument formed using a resin sheet cured body.
Fig. 2 is a schematic cross-sectional view illustrating an example of a configuration of a power semiconductor instrument formed using a resin sheet cured body.
Fig. 3 is a schematic cross-sectional view illustrating an example of a configuration of a power semiconductor instrument formed using a resin sheet cured body.
Fig. 4 is a schematic cross-sectional view illustrating an example of a configuration of a power semiconductor instrument formed using a resin sheet cured body.
Fig. 5 is a schematic cross-sectional view illustrating an example of a configuration of a power semiconductor instrument formed using a resin sheet cured body.
Fig. 6 is a schematic cross-sectional view illustrating an example of a configuration of a power semiconductor instrument formed using a resin sheet cured body.
Fig. 7 is a schematic cross-sectional view illustrating an example of a configuration of an LED light bar formed using a resin sheet cured body.
Fig. 8 is a schematic cross-sectional view illustrating an example of a configuration of an LED bulb formed using a resin sheet cured body.
Fig. 9 is a schematic cross-sectional view illustrating an example of a configuration of an LED bulb formed using a resin sheet cured body.
Fig. 10 is a schematic cross-sectional view illustrating an example of a configuration of an LED substrate formed using a resin sheet cured body.

### DESCRIPTION OF EMBODIMENTS

Hereinafter, modes for carrying out the invention are explained in detail. However, the invention is not limited to the following embodiments. In the following embodiments, constituent elements (including constituent processes and the like) described therein are not essential, except for the cases of, for example, being clearly indicated as essential or clearly considered essential in principle. The same shall apply to numerical values and numerical ranges, and the numerical values and the numerical ranges do not limit the invention.

In the present specification, the scope of the term "process" includes not only an independent process, but also a process that cannot be clearly distinguished from another process, but still achieves the specified purpose of the process. Further, each numerical range specified using "to" represents a range including the numerical values indicated before and after "to" as the minimum value and the maximum value, respectively. Furthermore, when plural substances each corresponding to a particular component are present in a composition, the content specified for the component in the composition refers to the total amount of the plural substances present in the composition, unless otherwise specified.

In the present specification, the scope of the term "layer" includes a shape configuration formed in a part of a face, in addition to a shape configuration formed on an entire face, when observed as a plane view.

In the specification, the term "laminate", "stack" and "layer" each indicate stacking of layers, in which the two or more layers may be bonded or separable.

### <Resin Composition>

The resin composition includes: a trifunctional or higher-functional first epoxy resin having, in a molecule thereof, a structure including two naphthalene rings linked together by an alkylene chain; a bifunctional second epoxy resin having a mesogenic structure in a molecule thereof; and a curing agent. The resin composition may further include other components, as necessary.

A resin composition having the above configuration has excellent flexibility before curing and has high handleability. Further, a cured product having excellent thermal conductivity and excellent adhesive property at high temperature can be obtained by thermally curing the resin composition by subjecting the resin composition to a heat treatment.

It is conceivable that the excellent adhesive property at high temperature and the excellent thermal conductivity after curing of the resin composition result from the inclusion of a combination of the epoxy resins having the specific structures and a curing agent in the resin composition. It is conceivable that the reason therefor is as follows.

The enhancement of thermal conductivity after curing is due to the regularity of the cured resin being higher than conventional resins. An increase in crosslinking density due to curing and stacking of crystalline skeletons having a mesogenic structure contained in the main chain of the epoxy resin due to intermolecular force, contribute to the enhancement of regularity. The stacking and the increase in crosslinking density are concurrently occurring phenomena, rather than independently occurring phenomena. This can be clearly observed when comparing a cured product obtained by curing a resin composition including the specific first epoxy resin, the specific second epoxy resin, and a curing agent with a cured product obtained by curing the specific first epoxy resin and a curing agent or a cured product obtained by curing the specific second epoxy resin and a curing agent; the resin composition in which the specific first epoxy resin and the specific second epoxy resin are used in mixture has the higher thermal conductivity. In general, crystals of ceramics, metals, or the like have higher crystal regularity when the crystals are formed from a single substance that is free of foreign substances, and, therefore, a higher thermal conductivity coefficient is obtained. The same applies to resins. Use of a single epoxy resin usually provides a higher thermal conductivity coefficient. However, in actuality, it is conceivable that a higher thermal conductivity coefficient is observed when the specific epoxy resins are mixed.

Regarding the adhesive property at high temperature, the present resin system does not aim to achieve a high crosslinking density, but has a high glass transition temperature. This is conceivably the reason why a favorable peel strength is exhibited up to 180°C, which is somewhat high for usage temperature of resin compositions.

Before curing the resin composition, the combination of the epoxy resins having the specific structures enables the preparation of a resin composition having flexibility and high handleability also at ordinary temperature, as well as a resin sheet in which the resin composition is used, although each of the epoxy resins has a melting point that is higher than ordinary temperature. In general, resins having a rigid skeleton of which the molecular chains stack after curing, such as mesogenic structures, are also rigid before curing, and inclusion of such resins results in resin compositions having low handleability. This is because the melting points of such resins are higher than ordinary temperature, and the rigidity of such resins is usually almost the same as, or worse than, that caused by incorporation of inorganic fillers. However, the combination of the first epoxy resin and the second epoxy resin may retard the crystallization of the epoxy resins due to insertion of other molecular chains into the mesogenic structures formed among the molecular chains. In the resin composition including the first epoxy resin and the second epoxy resin, the softening point of the resin composition is lowered utilizing the effect with respect to the retardation of crystallization. It is conceivable that the above is the reason why a resin composition that is flexible and has high handleability even at ordinary temperature can be obtained.

Hereinafter, the components forming the resin composition are described in detail.

### Epoxy Resin

The resin composition includes, as epoxy resins, a trifunctional or higher-functional first epoxy resin having, in a molecule thereof, a structure including two naphthalene rings linked together by an alkylene chain, and a bifunctional second epoxy resin having a mesogenic structure in a molecule thereof. The resin composition may further include another epoxy resin than the first epoxy resin or the second epoxy resin, if necessary.

The first epoxy resin may be any trifunctional or higher-functional epoxy resin having, within a molecule thereof, a structure including two naphthalene rings linked together by an alkylene chain, without particular limitations. The first epoxy resin is trifunctional or higher-functional, is preferably tetrafunctional.

The first epoxy resin is preferably a compound represented by the following Formula (I).

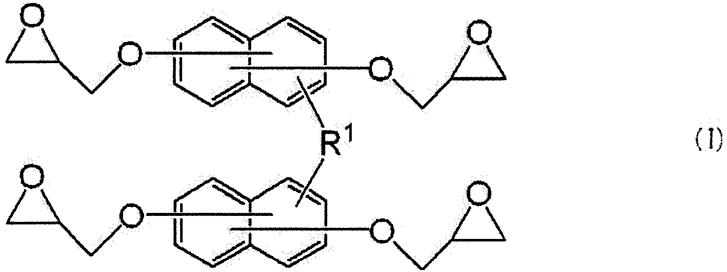

In Formula (I), R¹ represents an alkylene group having from 1 to 7 carbon atoms. R¹ preferably represents an alkylene group having from 1 to 5 carbon atoms, more preferably an alkylene group having from 1 to 3 carbon atoms, and still more preferably a methylene group. The alkylene group represented by R¹ may further have a substituent, if necessary. Examples of the substituent include an alkyl group, an aryl group, a halogen atom, and a hydroxyl group.

The position in each naphthalene ring to which R¹ bonds is not particularly limited, and may be the 1-position or the 2-position. The 1-position is preferable. The positions in the respective naphthalene rings to which R¹ bonds may be the same or different.

The compound represented by Formula (I) is more preferably a compound represented by the following Formula (IA).

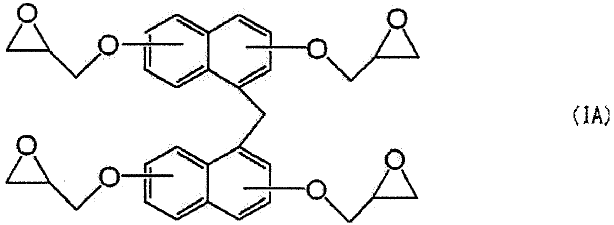

The second epoxy resin may be any bifunctional epoxy resin having a mesogenic structure in a molecule thereof, without particular limitations.

It is known that a favorable thermal conductivity can be obtained after an epoxy resin having a mesogenic structure is cured at a specific temperature. In the case of forming a resin cured material by allowing an epoxy resin to react with a curing agent at the specific temperature, use of an epoxy resin having a mesogenic structure may result in formation of a higher-order structure in the resin cured material, the higher order structure having regularity derived from the mesogenic structure. Here, the higher-order structure means a state in which molecules are aligned due to the mesogenic structure after the resin composition is cured.

It is preferable that the second epoxy resin is at least one selected from the group consisting of a compound represented by the following Formula (II) and a compound represented by the following Formula (III).

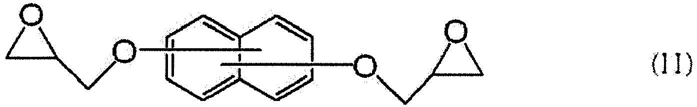

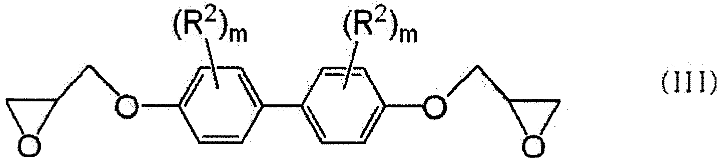

In Formula (III), each R² independently represents an alkyl group, an aryl group, or an aralkyl group. Each m independently represents an integer from 0 to 2. R² preferably represents an alkyl group.

Examples of the alkyl group represented by R² include a methyl group, an ethyl group, and a butyl group. Examples of the aryl group represented by R² include a phenyl group. Examples of the aralkyl group represented by R² include a benzyl group. The alkyl group, aryl group, and aralkyl group represented by R² may further have a substituent, if necessary. Examples of the substituent include an alkyl group, an aryl group, a halogen atom, and a hydroxyl group. R² preferably represents a methyl group or an ethyl group.

Common epoxy resins, other than the first epoxy resin or the second epoxy resin, may further be included as far as the properties are not significantly deteriorated.

A mesogenic structure means a functional group-derived structure that has a rigid molecular structure, and is derived from a functional group having a strong intermolecular force and orientating property. The mesogenic structure enables a higher-order structure to be formed in the resin after curing. Specific examples of the mesogenic structure include a structure in which two or more ring structures selected from aromatic rings and aliphatic rings are linked together by, for example, a chained or cyclic linking group including a single bond, an ester bond, an amide bond, an azo bond, or an unsaturated bond; and a structure including a polycyclic aromatic moiety.

The epoxy resin may include one kind of mesogenic structure, or two kinds of mesogenic structure. Specific examples of mesogenic structures that can favorably be used are illustrated below. However, the mesogenic structure is not limited to these specific examples.

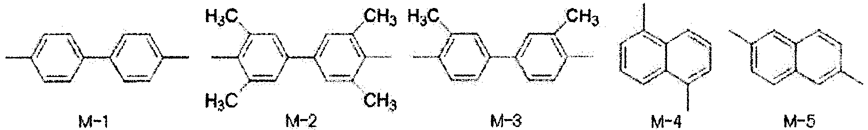

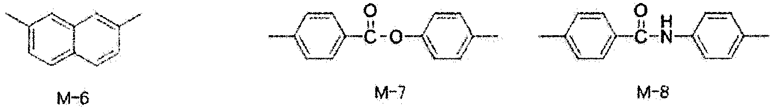

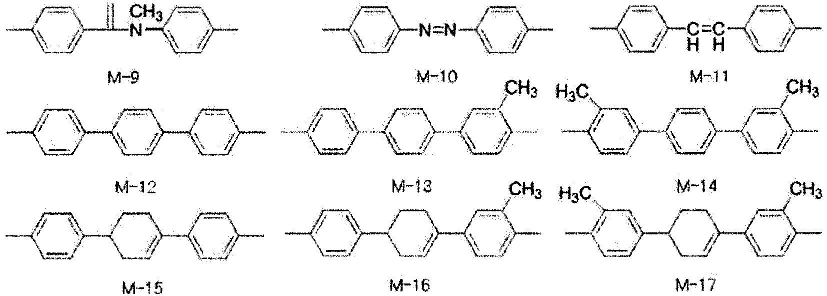

Specific examples of common epoxy resins include bisphenol A epoxy resins, bisphenol F epoxy resins, bisphenol S epoxy resins, and bisphenol AD epoxy resins, which are glycidyl ethers of bisphenol A, F, S, and AD, respectively; hydrogenated bisphenol A epoxy resins, hydrogenated bisphenol AD epoxy resins; phenol novolac glycidyl ethers (phenol novolac epoxy resins), cresol novolac glycidyl ethers (cresol novolac epoxy resins), bisphenol A novolac glycidyl ethers; dihydroxypentadiene glycidyl ethers (dihydroxypentadiene epoxy resins); and triphenylmethane epoxy resins.

There is no particular limitation as to the combination of the first epoxy resin and the second epoxy resin. It is preferable to use a compound represented by Formula (I) and at least one selected from the group consisting of a compound represented by Formula (II) and a compound represented by Formula (III) as epoxy resins.

There is a tendency that use of a compound represented by Formula (I) and at least one selected from the group consisting of a compound represented by Formula (II) and a compound represented by Formula (III) as epoxy resins further enhances the orientating property of molecular chains in the resin composition, as a result of which the thermal conductivity and heat resistance of the cured product tends to improve. Further, use of a compound represented by Formula (I) and at least one selected from the group consisting of a compound represented by Formula (II) and a compound represented by Formula (III) as epoxy resins and using a novolac resin having a structural unit represented by Formula (IV) described below as a curing agent causes formation of dense covalent bonds due to curing reactions between the curing agent and the specific epoxy resins, and further enhances the orientating property of molecular chains. As a result of this, there is a tendency that the thermal conductivity of the cured product further increases.

In the resin composition, the total proportion of the first epoxy resin and the second epoxy resin to all epoxy resins contained in the resin composition is preferably from 10% by mass to 100% by mass, more preferably from 20% by mass to 100% by mass, still more preferably from 20% by mass to 90% by mass, still more preferably from 30% by mass to 90% by mass, particularly preferably from 30% by mass to 80% by mass, and highly preferably from 40% by mass to 80% by mass. When the total of the first epoxy resin and the second epoxy resin is set to a percentage of from 10% by mass to 100% by mass, the thermal conductivity coefficient tends to increase.

Further, use of the first epoxy resin and the second epoxy resin in combination enables exertion of a synergistic effect of intermolecular forces due to the mesogenic structure and covalent bond formation through crosslinking reactions of the epoxy resin. This is because dilution exerts an effect on both of the effects. Specifically, a design in which the first epoxy resin is used alone as an epoxy resin without using the second epoxy resin is capable of attaining high crosslinking density. However, there are cases in which molecular chains of the epoxy resin become unable to move at some point during the reaction, and the reaction stops; this causes terminal functional groups to remain unused, which may deteriorate heat-resisting properties and electric properties. When the second epoxy resin having a mesogenic structure is used alone as an epoxy resin without using the first epoxy resin, the melting point of the epoxy resin increases, and the epoxy resin becomes hard to melt. Further, when the epoxy resin is subjected to high temperature in order to melt the epoxy resin, reactions prematurely occur and the resin cures in a state with insufficient flowability, as a result of which a satisfactory molded body is hard to obtain in some cases. Further, such an epoxy resin often separates from the filler due to the viscosity of the epoxy resin being excessively low. Accordingly, there are cases in which the reaction proceeds without sufficient intermingling of the epoxy resin with the curing agent, and thus the reaction terminates and sufficient intermolecular forces are not obtained. Moreover, separation of the curing agent and the epoxy resin tend to occur, and the epoxy resin *per se* is very hard to handle.

When the curing reaction proceeds without sufficient wetting of the member, to which the resin composition is to be attached, by the resin composition, the adhesive strength becomes low in some cases. However, when the first epoxy resin and the second epoxy resin are used in combination, the effect caused by dilution of the second epoxy resin by the first epoxy resin and the effect caused by dilution of the first epoxy resin by the second epoxy resin both work, and there is a tendency that the resin composition after curing can be made to have excellent adhesive property at high temperature and excellent thermal conductivity.

In the resin composition, the content ratio by mass of the first epoxy resin to the second epoxy resin (first epoxy resin : second epoxy resin) is preferably from 25:75 to 85:15, more preferably from 30:70 to 80:20, and still more preferably from 35:65 to 75:25.

In the case of using a compound represented by Formula (I) as the first epoxy resin and using a compound represented by Formula (II) as the second epoxy resin, the content ratio by mass of the first epoxy resin to the second epoxy resin (first epoxy resin : second epoxy resin) may be from 25:75 to 85:15, or from 30:70 to 80:20, or from 35:65 to 75:25.

Further, in the case of using a compound represented by Formula (I) as the first epoxy resin and using a compound represented by Formula (III) as the second epoxy resin, the content ratio by mass of the first epoxy resin to the second epoxy resin (first epoxy resin : second epoxy resin) may be from 25:75 to 85:15, or from 35:65 to 75:25, or from 40:60 to 65:35.

A common known technique for imparting flexibility to resin compositions before curing is adding an epoxy resin that is liquid at ordinary temperature, thereby lowering the softening points of resin compositions. However, liquid epoxy resins may lower the post-curing packing property and crosslinking density of the resin skeleton resulting from curing of the first epoxy resin and the second epoxy resin, and may lower post-curing properties such as thermal conductivity, glass transition temperature, and adhesive property. Nevertheless, resin compositions free of liquid epoxy resins are flexible before curing when the content ratio by mass of the first epoxy resin to the second epoxy resin (first epoxy resin:second epoxy resin) is set to a ratio of from 25:75 to 85:15. Therefore, flexibility before cuing can be imparted thereby, without taking measures to prevent lowering of properties. In a case in which a higher flexibility is required depending on the desired form or conditions, a liquid epoxy resin may be added to the resin composition. Even in this case, it is conceivable that a smaller addition amount would suffice.

The content percentage of the epoxy resin contained in the resin composition is not particularly limited. From the viewpoints of thermal conductivity and adhesive property, the content percentage of the epoxy resin is preferably from 3% by mass to 30% by mass with respect to the total solids mass in the resin composition. From the viewpoint of thermal conductivity, the content percentage of the epoxy resin is more preferably from 4% by mass to 25% by mass, and still more preferably from 5% by mass to 20% by mass. Here, the "total solids mass in the resin composition" means the total mass of non-volatile components, among the components that constitute the resin composition.

### (Curing Agent)

The resin composition includes a curing agent. Compounds capable of undergoing a curing reaction with an epoxy resin may be used as curing agents, without particular limitations. Specific examples of the curing agent include poly-addition type curing agents such as novolac resins, aromatic amine curing agents, aliphatic amine curing agents, mercaptan curing agents, and acid anhydride curing agents. A curing accelerator such as imidazole, triphenylphosphine, or a derivative obtained by introducing a side chain into any of the above compounds may be used together with the curing agent.

Among the those listed above, novolac resins are preferable, and novolac resins having a structural unit represented by Formula (IV) illustrated below (hereinafter also referred to as "specific novolac resins") are more preferable.

The specific novolac resins act as a curing agent, react with the epoxy resin described above to form resin cured materials, and exhibit electrically insulating property, adhesive property, and thermal conductivity. Inclusion of the specific epoxy resin described above and the specific novolac resin enables the resin composition to exhibit more improved flexibility before curing and exhibit more improved thermal conductivity and high-temperature adhesive property after curing.

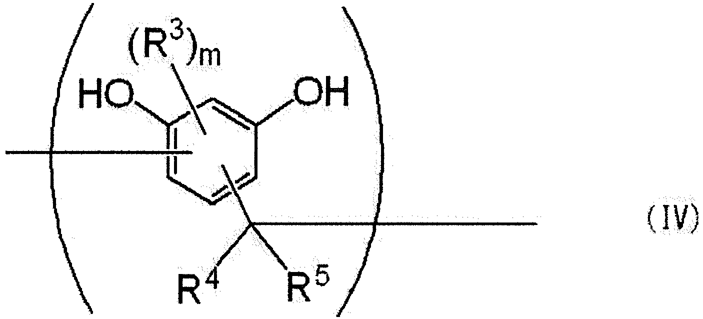

In Formula (IV), each R³ independently represents an alkyl group, an aryl group, or an aralkyl group, each of R⁴ and R⁵ independently represents a hydrogen atom, an alkyl group, an aryl group, or an aralkyl group, and m represents an integer from 0 to 2.

Further, m represents a number from 0 to 2. When m represents 2, two R³s may be the same or different. From the viewpoints of adhesive property and thermal conductivity, m preferably represents 0 or 1, and more preferably represents 0.

The specific novolac resin includes at least one compound having a structural unit represented by Formula (IV) above, and may include two or more compounds having a structural unit represented by Formula (IV) above.

The specific novolac resin, which includes a compound having a structural unit represented by Formula (IV), includes at least a partial structure derived from resorcinol as a phenol compound. The specific novolac resin may further include at least one kind of partial structure derived from a phenol compound other than resorcinol. Examples of the phenol compound other than resorcinol include phenol, cresol, catechol, hydroquinone, 1,2,3-trihydroxybenzene, 1,2,4-trihydroxybenzene, and 1,3,5-trihydroxybenzene. The specific novolac resin may include one kind of partial structure derived from any of these compounds, or include two or more kinds of partial structure derived therefrom in combination. Here, a partial structure derived from a phenol compound means a monovalent or divalent group formed by removing one hydrogen atom or two hydrogen atoms from a benzene ring portion of a phenol compound. The positions at which hydrogen atoms are removed are not particularly limited.

From the viewpoints of thermal conductivity, adhesive property, and storage stability, the at least one partial structure derived from a phenol compound other than resorcinol in the specific novolac resin is preferably at least one partial structure derived from at least one selected from the group consisting of phenol, cresol, catechol, hydroquinone, 1,2,3-trihydroxybenzene, 1,2,4-trihydroxybenzene, and 1,3,5-trihydroxybenzene, and more preferably a partial structure derived from at least one selected from the group consisting of hydroquinone, 1,2,4-trihydroxybenzene, and 1,3,5-trihydroxybenzene.

There is no particular limitation on the content percentage of the partial structure derived from resorcinol in the specific novolac resin. From the viewpoint of thermal conductivity, it is preferable that the content percentage of the partial structure derived from resorcinol with respect to the total mass of the specific novolac resin is 20% by mass or higher. From the viewpoint of still higher thermal conductivity, the content percentage is more preferably 50% by mass or higher. The upper limit of the content percentage of the partial structure derived from resorcinol with respect to the total mass of the specific novolac resin is not particularly limited, and it is preferable that the upper limit is, for example, 95% by mass or lower.

In Formula (IV), each of R⁴ and R⁵ independently represents a hydrogen atom, an alkyl group, an aryl group, or an aralkyl group. The alkyl group, aryl group, and aralkyl group that R⁴ or R⁵ may represent may further have a substituent, if necessary. Examples of the substituent include an alkyl group, an aryl group, a halogen atom, and a hydroxyl group.

From the viewpoints of storage stability and thermal conductivity, each of R⁴ and R⁵ preferably represents a hydrogen atom, an alkyl group, or an aryl group, more preferably represents a hydrogen atom, an alkyl group having from 1 to 4 carbon atoms, or an aryl group having from 6 to 10 carbon atoms, still more preferably represents a hydrogen atom or a phenyl group, and particularly preferably represents a hydrogen atom. Further, from the viewpoint of heat resistance, it is also preferable that at least one of R⁴ and R⁵ represents an aryl group having from 6 to 10 carbon atoms (more preferably, a phenyl group).

More specifically, the specific novolac resin is preferably a novolac resin that includes a compound having a structural unit represented by any one of Formula (IVa) to Formula (IVf) illustrated below.

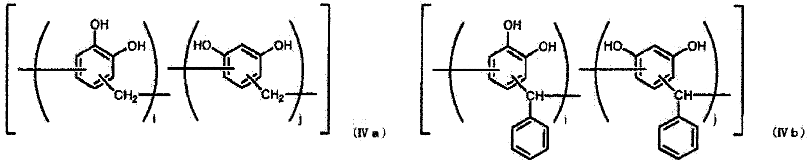

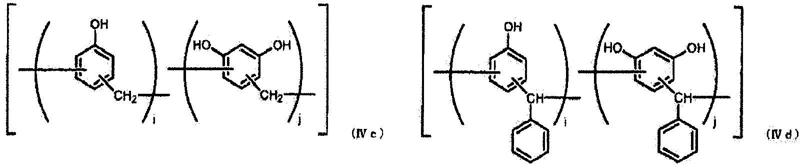

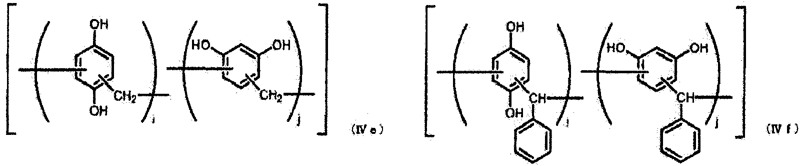

In Formula (IVa) to Formula (IVf), i and j represent content percentages (% by mass) of the structural units derived from the respective phenol compounds; i is from 2% by mass to 30% by mass, j is from 70% by mass to 98% by mass, and the sum of i and j is 100% by mass.

From the viewpoint of thermal conductivity, the specific novolac resin is preferably a novolac resin that includes at least one structural unit represented by at least one selected from the group consisting of Formula (IVa) and Formula (IVf), and in which i is from 2% by mass to 20% by mass and j is from 80% by mass to 98% by mass. From the viewpoints of elastic modulus and coefficient of linear expansion, the specific novolac resin is more preferably a novolac resin that includes a structural unit represented by Formula (IVa), and in which i is from 5% by mass to 10% by mass and j is from 90% by mass to 95% by mass.

The specific novolac resin includes a compound having a structural unit represented by Formula (IV) above, and preferably includes at least one compound represented by the following Formula (V).

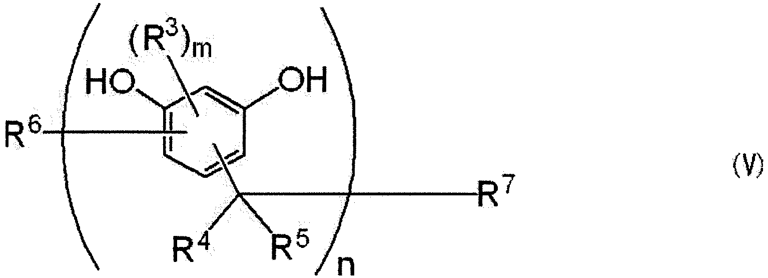

In Formula (V), R⁶ represents a hydrogen atom or a monovalent group derived from a phenol compound represented by Formula (Vp) illustrated below, and R⁷ represents a monovalent group derived from a phenol compound. R³, R⁴, R⁵, and m have the same definitions as R³, R⁴, R⁵, and m in Formula (IV), respectively. The monovalent group derived from a phenol compound and represented by R⁷ is a monovalent group formed by removing one hydrogen atom from a benzene ring portion of a phenol compound. The position at which a hydrogen atom is removed is not particularly limited.

Further, n is a number from 1 to 7, and represents the number of repetition of the structural unit represented by Formula (IV). When the specific novolac resin is a single compound, n is an integer. When the specific novolac resin includes plural molecular species, n is an average value of the numbers of structural units represented by Formula (IV) included in the molecular species, and n is a rational number. When the specific novolac resin includes plural compounds each having a structural unit represented by Formula (IV), the average value of n is preferably from 1.7 to 6.5, and more preferably from 2.4 to 6.1, from the viewpoints of adhesive property and thermal conductivity.

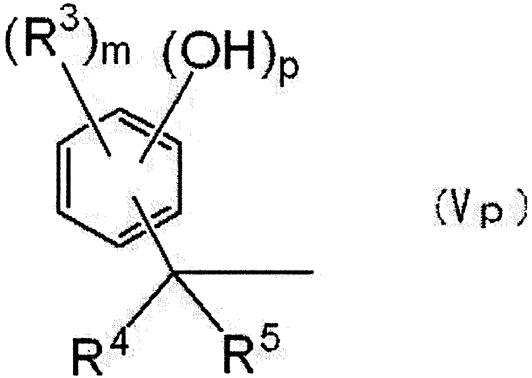

In Formula (Vp), p represents a number from 1 to 3. R³, R⁴, R⁵, and m have the same definitions as R³, R⁴, R⁵, and m in Formula (IV), respectively.

The phenol compounds in R⁶ or R⁷ may be any compound having a phenolic hydroxyl group, without particular limitations. Specific examples of the phenol compound include phenol, cresol, catechol, resorcinol, and hydroquinone. Among them, the phenol compound is preferably at least one selected from the group consisting of cresol, catechol, and resorcinol, from the viewpoints of thermal conductivity and storage stability.

The number average molecular weight of the specific novolac resin is preferably 800 or less from the viewpoints of thermal conductivity and moldability, more preferably from 300 to 750 from the viewpoints of elastic modulus and coefficient of linear expansion, and still more preferably from 350 to 550 from the viewpoints of moldability and adhesive strength.

The number average molecular weight of the specific novolac resin is measured using gel permeation chromatography (GPC), according to the ordinary method.

Further, from the viewpoint of flexibility, the specific novolac resin preferably further includes a monomer of a phenol compound that forms the novolac resin. In general, a novolac resin is synthesized by condensation polymerization of a phenol compound and an aldehyde compound. Accordingly, the "phenol compound that forms the novolac resin" refers to a phenol compound that is used for the synthesis of the novolac resin. The phenol compound contained in the specific novolac resin may be a phenol compound that has remained unused through the synthesis of novolac resin, or a phenol compound added after the synthesis of the novolac resin.

The content percentage of the phenol compound contained in the specific novolac resin is preferably from 5% by mass to 60% by mass, more preferably from 10% by mass to 55% by mass, and still more preferably from 15% by mass to 50% by mass.

The phenol compound included as a monomer in the specific novolac resin is selected in accordance with the structure of the specific novolac resin. The phenol compound is preferably at least one selected from the group consisting of resorcinol, catechol, 1,2,4-trihydroxybenzene, 1,3,5-trihydroxybenzene, and 1,2,3-trihydroxybenzene, and more preferably at least one selected from the group consisting of resorcinol and catechol.

The content percentage of the specific novolac resin in the resin composition is not particularly limited. The content percentage of the specific novolac resin is preferably from 0.3% by mass to 10% by mass with respect to the total solids mass in the resin composition, from the viewpoints of thermal conductivity and adhesive property. The content percentage of the specific novolac resin is more preferably from 0.5% by mass to 9% by mass, and still more preferably from 0.7% by mass to 8% by mass, with respect to the total solids mass in the resin composition, from the viewpoint of thermal conductivity.

From the viewpoints of electrically insulating property and heat resistance, the resin composition preferably includes, in addition to the specific novolac resin, at least one other novolac resin that does not include a structural unit represented by Formula (IV). The other novolac resin may be any novolac resin that does not include a structural unit represented by Formula (IV), without particular limitations. The other novolac resin may be selected, as appropriate, from novolac resins that are commonly used as curing agents for epoxy resins.

In a case in which the resin composition further includes other curing agents than the specific novolac resin, the content percentage of the other curing agents is not particularly limited. From the viewpoint of thermal conductivity, the content percentage of the other curing agents is preferably 30% by mass or lower, more preferably 20% by mass or lower, and still more preferably 10% by mass or lower, with respect to the specific novolac resin.

There is no particular limitation on the total content percentage of the specific novolac resin, other optional novolac resins and other optional curing agents (hereinafter also collectively referred to simply as "curing agent") in the resin composition. From the viewpoints of thermal conductivity and adhesive property, the total content percentage of the curing agent with respect to the total solids mass in the resin composition is preferably from 1% by mass to 10% by mass, more preferably from 1.2% by mass to 8% by mass, and still more preferably from 1.4% by mass to 7% by mass. Further, the content of the curing agent in the resin composition is preferably from 0.8 to 1.2, and more preferably from 0.9 to 1.1, with respect to the epoxy resin in terms of equivalents. Here, the equivalents refers to reaction equivalents; for example, the amount of a novolac resin in terms of equivalents is calculated assuming that one phenolic hydroxyl group reacts with one epoxy group, the amount of an amine in terms of equivalents is calculated assuming that one active hydrogen of an amino group reacts with one epoxy group, and the amount of an acidic anhydride in terms of anhydrous acid equivalents is calculated assuming that one acid anhydride group reacts with one epoxy group.

### (Filler)

The resin composition may include a filler, if necessary. The material of the filler may be any inorganic compound particle having electrically insulating property, without particular limitations, is preferably a material having high thermal conductivity and high volume resistivity. Specific examples thereof include inorganic compound particles of aluminum oxide, a hydrate of aluminum oxide, magnesium oxide, boron nitride, aluminum nitride, silicon nitride, talc, mica, aluminum hydroxide, barium sulfate, or the like. Among them, the filler is preferably inorganic compound particles of at least one selected from the group consisting of aluminum oxide, boron nitride, aluminum nitride, and aluminum hydroxide, from the viewpoints of thermal conductivity and electrically insulating property. The filler may be used singly, or in combination of two or more thereof.

In a case in which the resin composition includes a filler, it is preferable to use boron nitride particles having a volume average particle diameter of from 20 µm to 80 µm and inorganic particles having a volume average particle diameter of 1 µm or less in combination as fillers. There is a tendency that inclusion of boron nitride particles having a volume average particle diameter of from 20 µm to 80 µm and inorganic particles having a volume average particle diameter of 1 µm or less as fillers enables obtainment of a resin composition and a resin composition cured product having excellent thermal conductivity.

The Mohs hardness of boron nitride is 2. Compared with other electrically insulating ceramics such as aluminum oxide (alumina) or aluminum nitride, which have a hardness of, for example, 8, boron nitride has a low Mohs hardness and is soft. Further, boron nitride having a particle shape that is spherical or roundish is in a state in which primary particles are aggregated, and includes voids present inside the aggregated particles; therefore, the aggregated particles themselves are easily deformable although the aggregated particles are harder than molten resins.

Accordingly, boron nitride particles having a relatively large particle diameter contained in a resin sheet can be deformed during a heat and pressure application process, a lamination process, or a press process. As a result of the boron nitride particles pushing aside any resin present between the fillers during the deformation, the filler particles can easily approach each other. For example, when a filler including boron nitride particles having a volume average particle diameter of from 20 µm to 80 µm and another filler are present, the boron nitride particles can take positions between other hard filler particles while the boron nitride particles are deformed. As a result, a structure including filler particles continuously aligned in the thickness direction of a resin sheet or a resin sheet cured body with mutual contact (also referred to as a "heat conduction path") tends to form. It is conceivable that an increased thermal conductivity coefficient results from the above.

Although aluminum nitride particles are known as a filler having higher thermal conductivity than that of boron nitride particles, aluminum nitride particles are hard particles and harder to deform, and, therefore, the heat conduction path hardly occurs. It is conceivable that the above is the reason why the thermal conductivity improvement effect of aluminum nitride particle is smaller than that of boron nitride particles.

There is a tendency that the inclusion of inorganic particles having a volume average particle diameter of 1 µm or less in the resin composition reduces the fluidity of the resin composition, and, in the case of using the resin composition as an adhesive, ruduces bleeding of the resin composition. As the inorganic particles having a volume average particle diameter of 1 µm or less, alumina, aluminum hydroxide, boron nitride, silicon oxide, or the like is preferable, and alumina or aluminum hydroxide is more preferable.

The filler may be a filler having a single peak in the particle diameter distribution thereof, or a filler having plural peaks in the particle diameter distribution thereof. Further, the filler may be configured to include a combination of the filler having a single peak and the filler having plural peaks.

There is no particular limitation on the particle shape of the filler. Examples of the particle shape include a spherical shape, a roundish shape, a crushed shape, a scaly shape, and an aggregated particle shape. From the viewpoints of packing property and thermal conductivity, the particle shape of the filler is preferably a roundish shape, a spherical shape, or an aggregated particle shape.

The volume average particle diameter of the filler can be measured using a laser diffraction scattering method, a 3D CT method, or a method using a scanning electron microscope (SEM). Particle size distributions of fillers are broad, and particle diameters suitable for measurement differ by analyzers. Therefore, it is known that measurement can be performed with higher accuracy by using plural methods in combination.

In the case of using a laser diffraction scattering method, measurement can be performed using a laser diffraction scattering particle size distribution analyzer (for example, LS230, manufactured by Beckman Coulter, Inc.) after the filler is extracted from, for example, the resin composition, the resin sheet, or the resin sheet cured body. Specifically, the filler is mixed with water and sodium hexametaphosphate, which is a dispersant, such that the amount of the filler is within a range of from 1% by mass to 5% by mass and the amount of the sodium hexametaphosphate is from 0.01% by mass to 0.1% by mass, as a result of which a sample liquid is prepared. This sample liquid is dispersed by vibration for from 3 minutes to 5 minutes at a temperature of 23°C using an ultrasonic wave disperser (model number: UT-106, manufactured by Sharp Manufacturing Systems Corporation; output power100 W). About 2 mL of the dispersed sample liquid are added into a cell, and a particle size distribution is measured at 25°C using a laser diffraction scattering particle size distribution analyzer, at a setting including, for example, a refractive index of alumina of 1.77 and a refractive index of boron nitride of 2.17. The particle diameter (D50%) at which the cumulative volume reaches 50% is taken as the volume average particle diameter.

The filler contained in, for example, the resin composition, the resin sheet, or the resin sheet cured body may be extracted using, for example, an organic solvent, nitric acid, or aqua regia, and the extracted filler may thoroughly be dispersed using, for example, an ultrasonic wave disperser, to form a dispersion, and the volume average particle diameter can be measured by measuring the particle size distribution of the dispersion liquid. Alternatively, the filler may be extracted by removing resins by heating, and a dispersion liquid may be prepared from the extracted filler using the above method, and the particle size dispersion may then be measured.

In the case of using a 3D CT method, the volume average particle diameter of the filler can be measured using an SMX-160CTS manufactured by Shimadzu Corporation. Specifically, a 10 mm square piece may be cut out from the resin composition, the resin sheet, or the cured product thereof, and may be placed on a sample stand. The volume average particle diameter may be measured by irradiating an X-ray thereto. From a three-dimensional image taken under the measurement conditions including an X-ray tube voltage of 40 kV and an X-ray tube current of 100 mA, the proportions of the resin, the filler, and voids are determined by image analysis, and the volume average particle diameter of the filler can be calculated based on the proportions of the respective components. In some combinations of resins and filler species, it is difficult to distinguish the filler. In such a case, the particle diameter determination using the 3D CT method is more preferably combined with another method.

In the case of determining the volume average particle diameter of the filler using a method in which an SEM is used, an SEM FIB (Focused Ion Beam) may be used, and the measurement may be conducted using a NANO DUE'T model NB5000 manufactured by Hitachi High-Technologies Corporation, which is equipped with both of an FIB optical system and an SEM optical system. Specifically, while a Ga ion beam is made to vertically fall on the resin composition, resin sheet, or cured product thereof to perform processing of the cross-section, observation may be carried out using an SEM that is placed at an angle. Images are preferably taken with the pitch of the processing being set to be from 1 nm to 100 nm; the pitch is preferably adjusted in accordance with the size of the filler to be imaged.

From the obtained three-dimensional images, the filler structures are extracted using binarization, and the volume average particle diameter can be calculated therefrom based on the assumption that the particles are spherical.

From the viewpoint of thermal conductivity, the content percentage of boron nitride particles in the filler is preferably from 10% by volume to 100% by volume, and more preferably from 15% by volume to 97% by volume, with respect to the total volume of the filler being regarded as 100% by volume. From the viewpoint of adhesive property, the content percentage of boron nitride particles is still more preferably from 20% by volume to 95% by volume.

From the viewpoint of thermal conductivity, the content percentage of inorganic particles having a volume average particle diameter of 1 µm or less in the filler is preferably from 0.1% by volume to 30% by volume relative to the total volume of the filler being regarded as 100% by volume. From the viewpoint of adhesive property, the content percentage of inorganic particles having a volume average particle diameter of 1 µm or less is more preferably from 1 % by volume to 20% by volume.

The content percentage of the filler in the resin composition is preferably from 30% by volume to 90% by volume with respect to the total volume of solids in the resin composition, from the viewpoints of thermal conductivity and adhesive property. From the viewpoint of thermal conductivity, the content percentage of the filler is more preferably from 40% by volume to 80% by volume. The term "total volume of solids in the resin composition" means the total volume of non-volatile components, among the components that constitute the resin composition.

### (Other Components)

The resin composition may include other components, in addition to the above components, as necessary. Examples of the other components include organic solvents, curing accelerators, and dispersants.

### (Method of Producing Resin Composition)

As a method of producing the resin composition, common methods of producing a resin composition may be used without particular limitations. Mixing of the epoxy resins, the curing agent, and optional components such as a filler or a curing accelerators may be performed using a disperser such as an ordinary agitator, a grinding machine, a three roll mill, or a ball mill, which may be appropriately combined. Further, dispersing or dissolving may be performed with the addition of an appropriate organic solvent.

Specifically, for example, a resin composition may be prepared by dissolving or dispersing the epoxy resins, the curing agent, and optional components such as a filler in an appropriate organic solvent, and mixing other components such as a curing accelerator into the solution or dispersion, if necessary.

In the method of producing a resin sheet described below, at least a portion of the organic solvent is removed by drying in the drying process. Therefore, the organic solvent preferably has a low boiling point or a high vapor pressure. When the organic solvent remains in a large amount in the resin sheet, the organic solvent may exert an influence on thermal conductivity and electrically insulating performance. However, removal of the organic solvent may result in loss of adhesive property due to the sheet becoming too hard. Therefore, the organic solvent to be selected should have suitability for the drying method and drying conditions. An appropriate organic solvent may be selected in accordance with, for example, the resin to be used, the filler and the ease of drying at the time of sheet preparation. Examples of the organic solvent include an alcohol solvent such as methanol, ethanol, 1-propanol, 2-propanol, 1-butanol, 2-butanol, or cyclohexanol; a ketone solvent such as methyl ethyl ketone, cyclohexanone, or cyclopentanone; and a nitrogen-containing solvent such as dimethylformamide or dimethylacetamide. The organic solvent may be used singly, or in combination of two or more thereof.

The resin composition may be in the state of a single composition in which all of the components are uniformly mixed together, or configured as a composition set including a first composition and a second composition, the first composition including the first epoxy resin, the second epoxy resin, and the curing agent, and the second composition including an optional curing accelerator. Using the resin composition in the state of the single composition gets rid of the burden of mixing at the time of using the resin composition. Using the resin composition in the form of the composition set reduces the reaction of the epoxy resins with the curing agent, thereby improving the storability of the resin composition.

In the case of using the resin composition in the form of the composition set, it is preferable to configure the first composition to include the epoxy resins and the curing agent, but not include the optional curing accelerator, and configure the second composition to include the optional curing accelerator, but not include the epoxy resins and the curing agent. Further, optional components such as a filler may be contained in either one of the first composition or the second composition, or contained in both of the first composition and the second composition.

### <Resin Sheet>

The resin sheet includes the resin composition and has an average thickness of from 40 µm to 250 µm. Since the resin sheet is formed from the resin composition, the resin sheet has excellent storage stability before curing and excellent thermal conductivity after curing. Details of the resin composition are as described above.

The average thickness of the resin sheet is from 40 µm to 250 µm. From the viewpoint of achievement of both of thermal conductivity and electrically insulating property, the average thickness of the resin sheet is preferably from 50 µm to 240 µm, more preferably from 60 µm to 230 µm, and still more preferably from 70 µm to 220 µm. The average thickness of the resin sheet may be selected, as appropriate, based on the balance between electric properties, such as the voltage value to be electrically insulated or the current value, and the thermal resistance value between a heat generator and the resin sheet. Provided that the required thermal resistance value can be satisfied, a greater average thickness of the resin sheet is more preferable from the viewpoint of electrically insulating property. Here, the average thickness of the resin sheet is obtained as the arithmetic mean value of the thicknesses measured at 9 points using a micrometer (for example, MICROMETER IP65, manufactured by Mitutoyo Corporation).

The resin sheet is preferably configured to have a support on at least one side of the resin sheet, and more preferably configured to have a support on both sides of the resin sheet. This configuration enables prevention of adhesion of contaminants from the external environment to the adhesive face of the resin sheet, as well as protection of the resin sheet from an impact. Namely, the support functions as a protective film. Further, the support is preferably removed, if appropriate, at the time of use.

Examples of the support include plastic films such as polytetrafluoroethylene films, polyethyleneterephthalate (PET) films, polyethylene films, polypropylene films, polymethylpentene films, and polyimide films. These plastic films may be subjected, if necessary, to a surface treatment such as a primer coating, a UV treatment, a corona discharge treatment, a polishing treatment, an etching treatment, or a releasability-imparting treatment. As the support, a metal foil such as a copper foil or an aluminum foil, a metal plate such as an aluminum plate, or the like may also be used.

When the support is a plastic film, the average thickness thereof is not particularly limited. The average thickness is set, as appropriate, based on the knowledge of those skilled in the art in accordance with the average thickness of the resin sheet to be formed and the use for which the resin sheet is used. The average thickness of the plastic film is preferably from 10 µm to 150 µm, and more preferably from 25 µm to 110 µm, due to good economic efficiency and favorable handling property achievable thereby.

When the support is a metal foil, the average thickness hereof is not particularly limited. The average thickness may be selected, as appropriate, in accordance with, for example, the use for which the resin sheet is used. For example, the average thickness of the metal foil may be set to be from 10 µm to 400 µm, and the average thickness of the metal foil is preferably from 18 µm to 300 µm from the viewpoint of roll foil handling property.

The resin sheet preferably includes a first resin layer including the resin composition, and a second resin layer layered on the first resin layer and including the resin composition. For example, the resin sheet is preferably a laminated body of a first resin layer formed from the resin composition and a second resin layer formed from the resin composition. This configuration further improves the dielectric strength. The resin composition forming the first resin layer and the resin composition forming the second resin layer may have the same composition or mutually different compositions. From the viewpoint of thermal conductivity, the resin composition forming the first resin layer and the resin composition forming the second resin layer preferably have the same composition.

The resin sheet may be configured to have a metal foil on one side of the resin sheet and a plastic film on the opposite side of the resin sheet from the side having the metal foil.

It is preferable that the resin sheet is a laminated body including a first resin layer including the resin composition, and a second resin layer including the resin composition and layered on the first resin layer, and that the resin sheet further has a metal foil on one side of the laminated body, and that the resin sheet further has a protective film, such as a plastic film, on the other side of the laminated body. Namely, it is preferable that the resin sheet further has a metal foil and a protective film such as a plastic film, and that the metal foil, the first resin layer, the second resin layer, and the protective film such as a plastic film are provided in this order. This configuration produces a void closing effect, and thus the dielectric strength tends to further improve.

### (Method of Producing Resin Sheet)

The method used for preparing a resin sheet may be any method capable of forming a sheet-shaped resin layer having an average thickness of from 40 µm to 250 µm by using the resin composition, and may be selected, as appropriate, from common sheet production methods. Specific examples of methods of producing a resin sheet include a method including forming a resin composition layer by applying an organic-solvent-containing resin composition to a support so as to have a desired average thickness, and forming a resin layer by drying the formed resin composition layer to remove at least a portion of the organic solvent.

The method used for applying a resin composition and the drying method are not particularly limited, and may be selected, as appropriate, from common methods. Examples of the application method include a comma coater method, a die coater method, and a dip coating method. Examples of the drying method include drying by heating at normal pressure or reduced pressure, natural drying, and freeze-drying.

The thickness of the resin composition layer may be selected, as appropriate, such that the resin layer after drying has a desired average thickness. The thickness of the resin composition layer is preferably adjusted such that the average thickness of the resin layer after drying is from 40 µm to 250 µm, or from 50 µm to 250 µm. When the average thickness of the resin layer after drying is 40 µm or more, tendency toward void formation in the resin layer decreases, and the production plausibility tends to be higher. When the average thickness of the resin layer after drying is 250 µm or less, scattering of resin powder tends to reduce even in the case of forming a resin roll.

When the resin sheet is a laminated body, the resin sheet is preferably produced by stacking the first resin layer and the second resin layer, each of which is formed from the resin composition. This configuration further improves the dielectric strength.

Regarding the above, the following explanation may be made, for example. Specifically, the stacking of the two resin layers causes portions having smaller thicknesses (pinholes or voids) that may exist in either of the resin layers to be compensated by the other resin layer. It is conceivable that the compensation increases the minimum insulation thickness, and further improves the dielectric strength. Although the probability of generation of pinholes or voids is not high in the method of producing the resin sheet, the number of pinholes or voids is decreased to be close to zero by the stacking of the two resin layers since the probability that the thin portions overlap is the square of the probability of generation of pinholes or voids. It is conceivable that the effect in terms of further improved dielectric strength achieved by the stacking of the two resin layers results from the above mechanism since dielectric breakdown occurs at portions that are weakest in terms of electrical insulation. Further, it is conceivable that the increased probability of contact between fillers caused by the stacking of the two resin layers produces an effect in terms of improvement of thermal conductivity.

The method of producing the resin sheet preferably includes a process of layering the second resin layer formed from the resin composition on the first resin layer formed from the resin composition, to obtain a laminated body, and a process of subjecting the obtained laminated body to a heating and pressurizing treatment. This production method further improves the dielectric strength.

The resin sheet preferably further has a metal foil on one side of the laminated body and a protective film, such as a plastic film, on the other side of the laminated body. The method used for producing a resin sheet having such a configuration preferably includes a process of stacking a first resin layer and a second resin layer such that the first and second resin layers contact each other, the first resin layer being formed from the resin composition and being provided on a metal foil, and the second resin layer being formed from the resin composition and being provided on a protective film such as a plastic film. A void closing effect can more effectively be obtained thereby.

The first resin layer may be formed, for example, by applying the resin composition to a metal foil to form a resin composition layer wherein the resin composition includes an organic solvent, and drying the formed resin composition layer to remove at least a portion of the organic solvent. The second resin layer may be formed, for example, by applying a resin composition to a plastic film to form a resin composition layer, wherein the resin composition includes an organic solvent, and drying the formed resin composition layer to remove at least a portion of the organic solvent.

The average thicknesses of the first resin layer and the second resin layer may be selected, as appropriate, such that the laminated body formed therefrom has an average thickness of from 40 µm to 250 µm. Each of the average thickness of the first resin layer and the average thickness of the second resin layer may be, for example, from 10 µm to 240 µm, and is preferably from 20 µm to 230 µm. When the average thickness is 10 µm or more, the tendency toward void formation inside the resin layer decreases, and the production plausibility tends to be higher. When the average thickness is 240 µm or less, the tendency toward crack formation in the sheet decreases. The average thickness of the first resin layer and the average thickness of the second resin layer may be the same as or different from each other.

The laminated body including the first resin layer and the second resin layer stacked one on the other is preferably subjected to a heating and pressurizing treatment. The heating and pressurizing treatment enables production of a resin sheet having a further improved thermal conductivity. The method used for the heating and pressurizing treatment may be any method capable of applying a prescribed pressure and heat, without particular limitations, and may be selected, as appropriate, from common methods for heating and pressurizing treatments. Specific examples thereof include a lamination treatment, a press treatment, and a metal roll treatment. Heating and pressurizing treatments include methods in which treatment is performed at ordinary pressure, and vacuum treatments in which treatment is performed at reduced pressure. Vacuum treatments are more preferable, but the manner of treatment is not limited thereto.

In a case in which resin layers are formed from the resin composition, the surface of the laminated body before the heating and pressurizing treatment may have irregularities due to filler or the like, rather than being smooth. The thickness of a resin sheet obtained by subjecting this laminated body to a heating and pressurizing treatment may be smaller than the sum of the thicknesses of the resin layers, rather than equal to the sum of the thicknesses of the resin layers. It is conceivable that this is caused by, for example, a change in filler packing property, overlapping of protrusions and depressions on the surfaces, improvement of sheet uniformity, and closure of voids, which occur during the heating and pressurizing treatment.

The resin sheet is preferably formed of a resin layer obtained by removing at least a portion of organic solvent from the resin composition layer. Further, the resin sheet is more preferably a sheet obtained by further subjecting the resin layer from which at least a portion of organic solvent has been removed to a heating and pressurizing treatment so as to allow the resin composition forming the resin layer to get into a semi-cured state (B-stage). In the present specification, a resin sheet obtained by drying a resin composition layer formed from the resin composition is also referred to as the "A-stage sheet", and a resin sheet obtained by further subjecting the A-stage sheet to a heating and pressurizing treatment is also referred to as the "B-stage sheet". With respect to the A-stage, the B-stage, and the later-described C-stage, the specifications provided in JIS K6900: 1994 may be referenced.

The B-stage sheet is preferably in a state in which the resin composition is semi-cured. Here, the B-stage sheet has a resin sheet viscosity of from 10⁴ Pa·s to 10⁹ Pa·s at ordinary temperature (at 25°C), and from 10² Pa·s to 10⁷ Pa·s at 100°C, and exhibits a 0.001% to 50% viscosity decrease when the temperature is changed from ordinary temperature (25°C) to 100°C. The later-described resin sheet cured body after curing does not melt even when heated. The viscosity described above can be measured by a dynamic viscoelasticity measurement (frequency: 1 Hz, load: 40 g, temperature elevation rate: 3°C/minute).

When the resin sheet is a B-stage sheet, the resin sheet has improved handling property. This is because the B-stage sheet has an increased elastic modulus and enhanced strength due to the curing that has proceeded, as compared with the A-stage sheet. However, the degree of curing of the resin sheet is preferably regulated to a degree at which the resin sheet can flexibly be handled. Examples of the method used for allowing the resin layer to get into a semi-cured state to obtain the B-stage sheet include a method of performing a heating and pressurizing treatment.

The method used for subjecting the resin layer to a heating and pressurizing treatment is not particularly limited as far as the method is capable of allowing the resin layer to get into a semi-cured state. For example, heat presses and laminators may be used for subjecting the resin sheet to a heating and pressurizing treatment. The heating and pressurizing conditions for allowing the resin layer to get into a semi-cured state may be selected, as appropriate, in accordance with the configuration of the resin composition, and an example is a condition including a heating temperature of from 40°C to 200°C, a pressure of from 0.1 MPa to 100 MPa, and a duration of from 0.3 minutes to 30 minutes.

The resin sheet in the B-stage state is preferably bendable along the outer circumferential face of a circular cylinder having a diameter of 10 mm. With the bendability, there is a tendency that effects in terms of enhancement of thermal conductivity coefficient and improvement in electrical insulation property at practical use can be obtained. The method used for determining whether or not the resin sheet in the B-stage state is bendable along the outer circumferential face of a circular cylinder having a diameter of 10 mm is specifically as follows.

A B-stage sheet piece cut in the size of 50 mm × 10 mm is pressed against a circular cylinder having a diameter of 10 mm, and the presence or absence of cracks in the sheet is determined visually. The test temperature is 20°C ± 3°C, and the assessment is carried out at five different positions for one sample. Of the five spots, if the number of positions at which cracks are not observed is two or more, the sample is judged as bendable along the outer circumferential face of a circular cylinder having a diameter of 10 mm.

### <Resin Sheet Cured Body>

The resin sheet cured body is a heat-treated product of the resin sheet. Namely, the resin sheet cured body is formed by heat-treating the resin sheet so as to cure the resin composition forming the resin sheet. Accordingly, the resin sheet cured body includes a resin cured material and, if necessary, other components such as a filler, the resin cured material including structural units derived from the first epoxy resin, the second epoxy resin, and the curing agent.

The resin sheet cured body preferably includes a resin cured material derived from the compound represented by Formula (I), at least one selected from the group consisting of the compound represented by Formula (II) and the compound represented by Formula (III), and the curing agent.

In the resin sheet cured body, the contact between filler particles provides a high thermal conductivity. Since resins and fillers have greatly different thermal conductivities, it is preferable, in a mixture of a resin and a filler, to have highly heat-conducting filler particles approach each other as close as possible, thereby shortening the distance between filler particles. For example, when filler particles, having a higher thermal conductivity coefficient than those of resins, contact each other without the presence of resins therebetween, a heat conduction path is formed, and high thermal conductivity tends to be obtained due to the formation of a pathway that easily conducts heat.

The heat treatment conditions used in the production of the resin sheet cured body may be selected, as appropriate, in accordance with the configuration of the resin composition. For example, the resin sheet may be heated at from 120°C to 250°C, for from 1 minute to 300 minutes. From the viewpoints of the glass transition temperature of the epoxy resin, thermal conductivity, and adhesive property, the heat treatment conditions preferably include a process of gradually elevating the temperature in order to facilitate the formation of a three-dimensional crosslinked structure. For instance, the resin sheet is more preferably subjected to at least two stages of heating including heating at from 100°C to 160°C and heating at from 160°C to 250°C, and still more preferably subjected to three or more stages of heating each within the above temperature range. The multistage heating decreases unreacted moieties in the epoxy resins and the curing agent, thereby improving the characteristics due to increased crosslinking density as well as preventing thermal decomposition of unreacted moieties, and also producing an effect in terms of preventing overheating of the central part of the resin due to reaction heat.

It is known that a high thermal conductivity can be achieved by allowing an epoxy resin having a mesogenic structure, used as an epoxy resin, to react with a curing agent at a specific temperature, thereby forming a resin cured material. In this regard, the following explanation, for example, may be given.

A higher order structure having a high regularity can be formed in a resin cured material formed using an epoxy resin having a mesogenic structure in a molecule thereof and the specific novolac resin. However, at temperatures outside the specific temperature range, the structure having a high regularity is not obtained in some cases, and the desired thermal conductivity coefficient is not obtained in some cases. Under the above heat treatment conditions for the production of a resin sheet cured body, a cured product having a structure with high regularity tends to be obtained and the thermal conductivity coefficient tends to improve when forming a resin cured material using an epoxy resin having a mesogenic structure in a molecule thereof and the specific novolac resin.

### <Resin Sheet Laminated Body>

The resin sheet laminated body includes the resin sheet and a metal plate or heat radiation plate disposed on at least one side of the resin sheet. Details of the resin sheet in the resin sheet laminated body are as described above. Examples of the metal plate or heat radiation plate include copper plates, aluminum plates, and ceramic plates. The thickness of the metal plate or heat radiation plate is not particularly limited, and may be selected, as appropriate, in accordance with the purpose and the like. As the metal plate or heat radiation plate, a metal foil such as a copper foil or an aluminum foil may be used.

In the resin sheet laminated body, a metal plate or a heat radiation plate is disposed on at least one side of the resin sheet, more preferably on both sides of the resin sheet.

The resin sheet laminated body can be produced by a production method including a process of disposing a metal plate or a heat radiation plate on at least one side of the resin sheet, to obtain a laminated body.

As the method of disposing a metal plate or a heat radiation plate on the resin sheet, common methods may be used without particular limitations. An example thereof is a method including adhering a metal plate or a heat radiation plate to at least one side of the resin sheet. The adhesion method may be either a method based on adhesion due to a resin component contained in the resin sheet, or a method based on the pressure-sensitive adhesiveness of a grease coated on a surface of the resin sheet. Selection from these methods may appropriately be made in accordance with, for example, the required properties and the configuration of a semiconductor instrument configured using the resin sheet laminated body. Specific examples of the adhesion method include a press method and a lamination method. Conditions for a press method and a lamination method can be selected, as appropriate, in accordance with the configuration of the resin sheet. The heating and pressurizing method used in the press process is not particularly limited. Examples thereof include a heating and pressurizing method using a press apparatus, a heating and pressurizing method using a lamination apparatus, a heating and pressurizing method using a metal roll press apparatus, and a heating and pressurizing method using a vacuum press apparatus.

The conditions used for the heating and pressurizing may include, for example, a temperature of from 60°C to 250°C, a pressure of from 0.5 MPa to 100 MPa, and a duration of from 0.1 minutes to 360 minutes, and preferably includes a temperature of from 70°C to 240°C, a pressure of from 1 MPa to 80 MPa, and a duration of from 0.5 minute to 300 minutes. The heating and pressurizing treatment may be performed at atmospheric pressure (at normal pressure), but is preferably performed at reduced pressure. The pressure reduction condition is preferably 30,000 Pa or less, and more preferably 10,000 Pa or less.

The resin sheet laminated body may include a metal plate or a heat radiation plate on one side of the resin sheet, and an attached member on the opposite side from the side on which the metal plate or heat radiation plate is disposed. By heat-treating the resin sheet laminated body to cure the resin sheet included in the resin sheet laminated body, a resin sheet laminated body cured product having excellent thermal conductivity between the attached member and the metal plate or heat radiation plate can be formed.

The attached member is not particularly limited. Examples of the material of the attached member include metals, resins, ceramics, and composite materials that are mixture of these materials, such as resin/ceramic or resin/metal. Examples of the shape of the attached member include various shapes such as a thin film shape, a plate shape, and a box shape.

The resin sheet laminated body may include a metal plate or a heat radiation plate disposed on one side of the resin sheet and a metal foil disposed on the opposite side from the side at which the metal plate or heat radiation plate is disposed.

### <Resin Sheet Laminated Body Cured Product and Production Method Thereof>

The resin sheet laminated body cured product is a heat-treated product of the resin sheet laminated body. The method used for producing the resin sheet laminated body cured product includes a process of disposing a metal plate or a heat radiation plate on at least one side of the resin sheet and a process of curing the resin sheet by applying heat to the resin sheet, and optionally include other processes, if necessary.

As the method used for disposing a metal plate or a heat radiation plate on the resin sheet, the methods and conditions disclosed in the section for the resin sheet laminated body may be applied.

In the method of producing the resin sheet laminated body cured product, the resin sheet is cured by heating after the process of disposing the metal plate or heat radiation plate. By heating the resin sheet laminated body, the thermal conductivity is further enhanced. The heating of the resin sheet laminated body may be performed, for example, at from 120°C to 250°C for from 10 minutes to 300 minutes. From the viewpoint of thermal conductivity, the conditions for heating of the resin sheet laminated body preferably include a temperature at which a higher order structure tends to form in the cured product. For example, in the heating of the resin sheet laminated body, it is more preferable to perform at least two stages of heating including heating at from 100°C to 160°C and heating at from 160°C to 250°C, and still more preferably three or more stages of heating, each within the above temperature range.

### <Semiconductor Instrument>

The semiconductor instrument includes a semiconductor device and a resin sheet cured body disposed on the semiconductor device. The semiconductor instrument may further include other members, if necessary. As the semiconductor device, common semiconductor devices may be used without particular limitations. Specific examples of the semiconductor device include power semiconductor devices such as insulated gate bipolar transistors (IGBTs) and thyristors, and LED devices. Hereinafter, examples of the configuration of the semiconductor instrument are described with reference to the drawings.

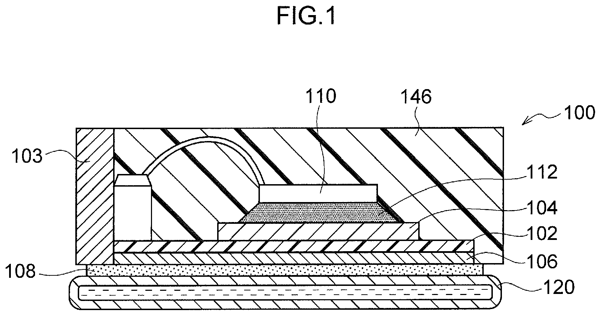

Fig. 1 to Fig. 6 illustrates examples of the configuration of the power semiconductor instrument formed using the resin sheet cured body. In the drawing, explanation of the same symbol may be omitted.

Fig. 1 is a schematic cross-sectional view illustrating an example of the configuration of a power semiconductor instrument 100 configured by including, in a housing 103: a copper plate 104 on which a power semiconductor device 110 is disposed with a solder layer 112 disposed therebetween; a resin sheet cured body 102; and a heat radiation base 106 disposed on a water cooling jacket 120 with a grease layer 108 disposed therebetween. The region around the power semiconductor device 110 is sealed with a sealing resin 146. Since heat generators including the power semiconductor device 110 are in contact with a heat radiation member with the resin sheet cured body 102 disposed therebetween, heat is efficiently radiated. The heat radiation base 106 may be formed using a material having copper, aluminum or the like, which have thermal conductivity. Examples of the power semiconductor device 110 include IGBTs and thyristors.

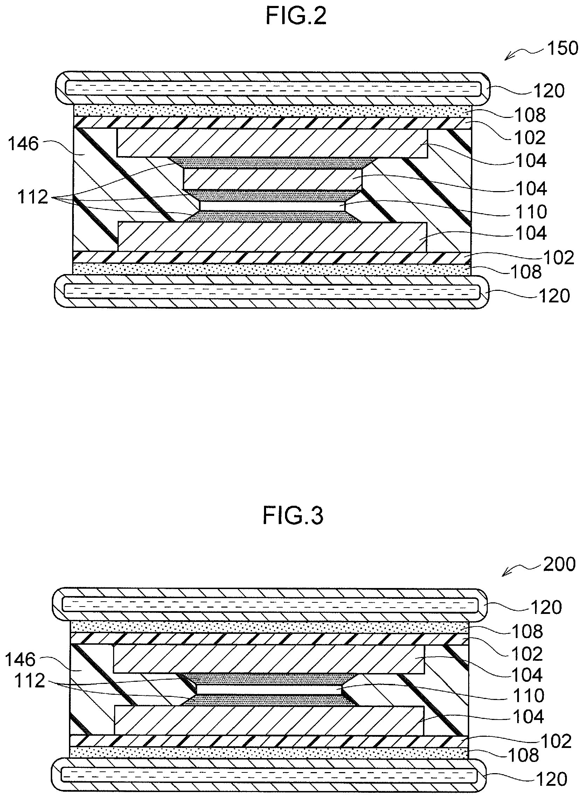

Fig. 2 is a schematic cross-sectional view illustrating an example of the configuration of a power semiconductor instrument 150 in which a cooling member is disposed on both sides of a power semiconductor device 110. In the power semiconductor instrument 150, a cooling member disposed on the upper face of the power semiconductor device 110 is configured to include two layers of copper plate 104 with a solder layer 112 disposed therebetween. This configuration more effectively reduces occurrence of chip cracking and solder cracking. In Fig. 2, the copper plate 104 disposed further from the semiconductor device 110 is connected to a water cooling jacket 120 via a resin sheet cured body 102 and a grease layer 108. In the cooling member disposed on the lower face of the semiconductor device 110, one layer of copper plate 104 is connected to a water cooling jacket 120 via a resin sheet cured body 102 and a grease layer 108. Further, a copper foil, an aluminum foil, or the like may be bonded to a face of the resin sheet cured body 102 at the grease layer 108 side. Although, the resin sheet cured body 102 and the water cooling jacket 120 are arranged with the grease layer 108 disposed therebetween in Fig. 2, the resin sheet cured body 102 and the water cooling jacket 120 may be arranged so as to directly contact with each other.

Fig. 3 is a schematic cross-sectional view illustrating an example of the configuration of a power semiconductor instrument 200 in which a cooling member is disposed on both sides of a power semiconductor device 110. In the power semiconductor instrument 200, each of the cooling members disposed on both sides of the power semiconductor device 110 is configured to include one layer of copper plate 104. Further, a cooper foil, an aluminum foil, or the like may be bonded to a face of resin sheet cured body 102 at the grease layer 108 side. Although the resin sheet cured body 102 and a water cooling jacket 120 are arranged with the grease layer 108 disposed therebetween in Fig. 3, the resin sheet cured body 102 and the water cooling jacket 120 may be arranged so as to directly contact with each other.

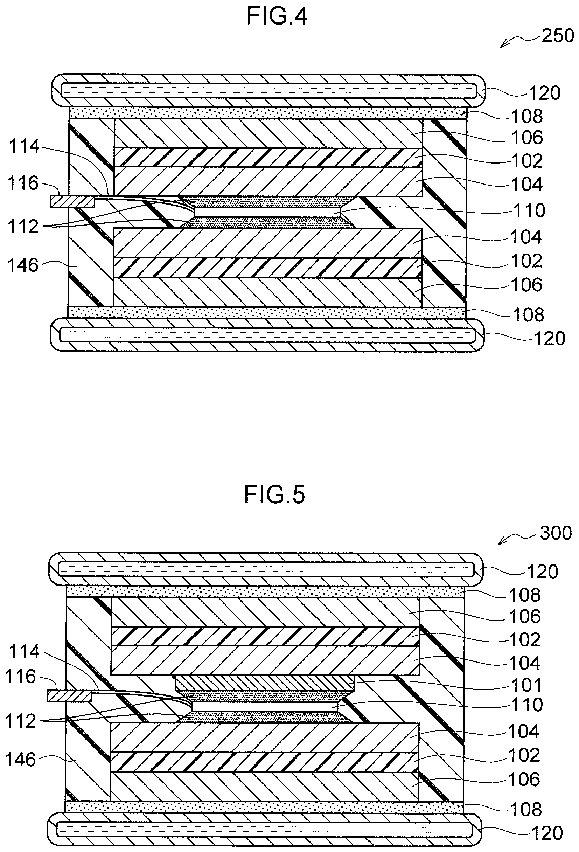

Fig. 4 is a schematic cross-sectional view illustrating an example of the configuration of a power semiconductor instrument 250 in which a cooling member is disposed on both sides of a power semiconductor device 110. In the power semiconductor instrument 250, the cooling member disposed on the upper face of the power semiconductor device 110 is configured to include copper plate 104 with a solder layer 112 disposed between the power semiconductor device 110 and the copper plate 104. This configuration more effectively reduces the occurrence of chip cracking and solder cracking. Further, since a resin sheet cured body 102 is included in the module, influences from sheet cracking, ambient vibration or the like can be prevented, whereby reliability is enhanced. In Fig. 4, each of the copper plates 104 disposed on the upper face and the lower face is connected to a water cooling jacket 120 via the resin sheet cured body 102, a heat radiation base 106, and a grease layer 108. Examples of the heat radiation base 106 include a copper foil and an aluminum foil. The power semiconductor device 110 is connected to an external terminal 116 via a wiring member 114. Although the resin sheet cured body 102 and the water cooling jacket 120 are arranged with the heat radiation base 106 and the grease layer 108 disposed on the resin sheet cured body 102 in Fig. 4, the resin sheet cured body 102 and the water cooling jacket 120 may be arranged so as to be directly contact with each other.

Fig. 5 is a schematic cross-sectional view illustrating an example of the configuration of a power semiconductor instrument 300 in which a cooling member is disposed on both sides of a power semiconductor device 110. In the power semiconductor instrument 300, each of the cooling members disposed on both faces of the power semiconductor device 110 is configured to include one layer of copper plate 104. On one face of the power semiconductor device 110, the copper plate 104 is disposed with a spacer 101 disposed between the power semiconductor device 110 and the copper plate 104. Since a resin sheet cured body 102 is included in the module, influences from sheet cracking, ambient vibration or the like can be prevented, and reliability is enhanced. In Fig. 5, the copper plate 104 is connected to a water cooling jacket 120 via the resin sheet cured body 102, a heat radiation base 106, and a grease layer 108. Further, the power semiconductor device 110 is connected to an external terminal 116 via a wiring member 114. Although the resin sheet cured body 102 and the water cooling jacket 120 are arranged with the heat radiation base 106 and the grease layer 108 disposed on the resin sheet cured body 102 in Fig. 5, the resin sheet cured body 102 and the water cooling jacket 120 may be arranged so as to directly contact with each other.

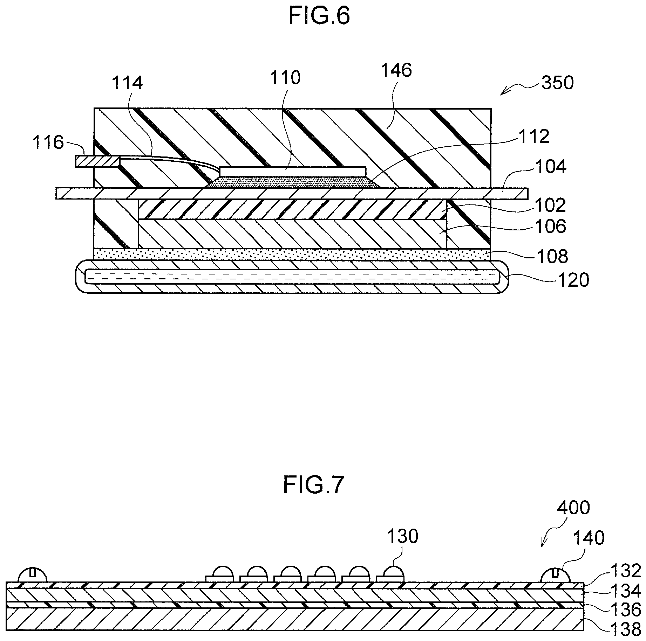

Fig. 6 is a schematic cross-sectional view illustrating an example of the configuration of a power semiconductor instrument 350 configured to include a copper plate 104, a resin sheet cured body 102 and a heat radiation base 106, wherein a power semiconductor device 110 is disposed on the copper plate 104 with a solder layer 112 disposed therebetween, and the heat radiation base 106 is disposed on a water cooling jacket 120 with a grease layer 108 disposed therebetween. Since a heat generator including the power semiconductor device 110 is in contact with the heat radiation member with the resin sheet cured body 102 disposed therebetween, heat is efficiently radiated. The heat radiation base 106 may be formed using copper, aluminum, or the like which have thermal conductivity.

### <LED instrument>

The LED instrument is configured to include an LED device, a resin sheet cured body, and a substrate, which are stacked in this order. The LED instrument may further include other members, if necessary. Examples of the substrate include an aluminum substrate.

Figs. 7 to 10 illustrate examples of the configuration of the LED instrument formed using the resin sheet cured body.

Fig. 7 is a schematic cross-sectional view illustrating an example of the configuration of a LED light bar 400 formed using the resin sheet cured body. The LED light bar 400 is configured by disposing a housing 138, a grease layer 136, an aluminum substrate 134, a resin sheet cured body 132, and LED chips 130 in this order, and fixing them together using screws 140. Since the LED chips 130, which are heat generators, are disposed on the aluminum substrate 134 with the resin sheet cured body 132 disposed therebetween, heat can efficiently be radiated.

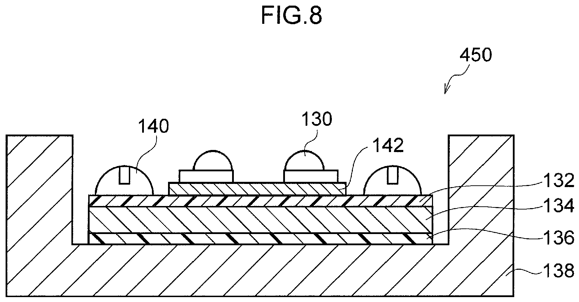

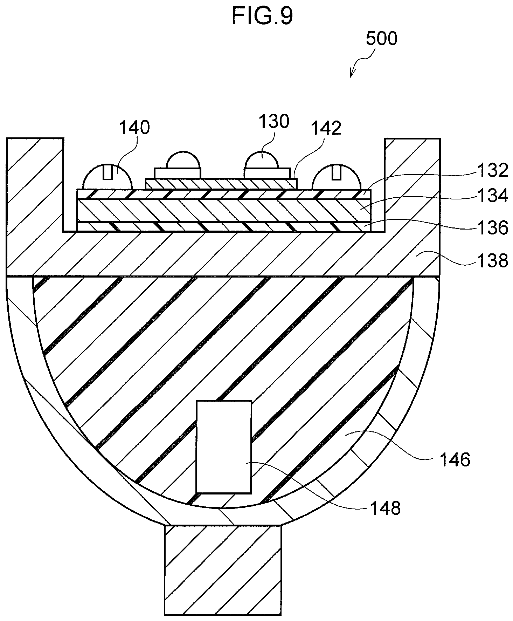

Fig. 8 is a schematic cross-sectional view illustrating an example of the configuration of a light-emitting unit 450 of an LED bulb. The light-emitting unit 450 of the LED bulb is configured by disposing a housing 138, a grease layer 136, an aluminum substrate 134, a resin sheet cured body 132, a circuit layer 142, and LED chips 130 in this order, and fixing them together using screws 140. Further, Fig. 9 is a schematic cross-sectional view illustrating an example of the entire structure of a LED bulb 500. A housing 138 of the light-emitting unit of the LED bulb is disposed on a sealing resin 146 that encapsulates a power source member 148.

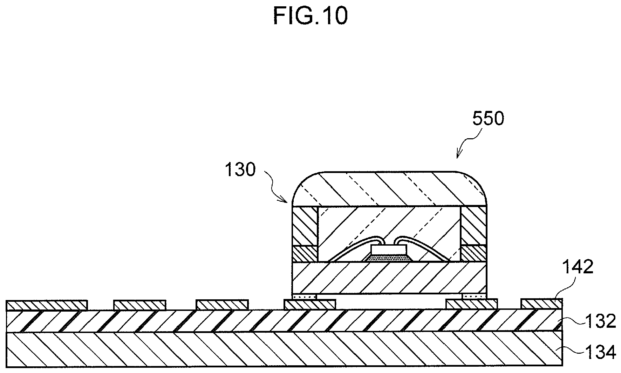

Fig. 10 is a schematic cross-sectional view illustrating an example of the configuration of a LED substrate 550. The LED substrate 550 is configured by disposing an aluminum substrate 134, a resin sheet cured body 132, a circuit layer 142, and a LED chip 130 in this order. Since the LED chip 130, which is a heat generator, is disposed on the aluminum substrate 134 with the circuit layer 142 and the resin sheet cured body 132 disposed therebetween, heat can efficiently be radiated.

### EXAMPLES

Hereinafter, the present invention is more specifically described with reference to examples. However, the invention is not limited to these examples. Unless otherwise stated, "part(s)" and "%" are based on mass.

The materials used for the production of resin sheets and the abbreviations thereof are indicated below.

### (Filler)

- AA-18: aluminum oxide particles, product name: AA-18, manufactured by Sumitomo Chemical Co., Ltd., volume average particle diameter: 18 µm
- AA-3: aluminum oxide particles, product name: AA-3, manufactured by Sumitomo Chemical Co., Ltd., volume average particle diameter: 3 µm
- AA-04: aluminum oxide particles, product name: AA-04, manufactured by Sumitomo Chemical Co., Ltd., volume average particle diameter: 0.4 µm
- HP: boron nitride particles, product name: HP40, manufactured by Mizushima Ferroalloy Co., Ltd., volume average particle diameter: 45 µm

### (Curing Agent (including novolac resin))

- CRN: catechol resorcinol novolac resin, manufactured by Hitachi Chemical Co., Ltd., number average molecular weight: 425, content percentage of phenol compound: 35%

### (Epoxy Resin)

- TN: 2,2',7,7'-tetra(2,3-epoxypropoxy)-1,1'methylenebisnaphthalene type epoxy resin, product name: HP4710, manufactured by DIC Corporation
- DN: 1,6-bis(2,3-epoxypropoxy)naphthalene type epoxy resin, product name: HP-4032D, manufactured by DIC Corporation
- BP: biphenyl type epoxy resin, model number: YL6121H, manufactured by Mitsubishi Chemical Corporation
- BIS-A/F: bisphenol A/F mixed type epoxy resin, model number: ZX-1059, manufactured by Nippon Steel & Sumikin Chemical Co., Ltd.
- TPM: triphenylmethane type epoxy resin, product name: EPPN-502H, manufactured by Nippon Kayaku Co., Ltd.
- MM:
   1-{(3-methyl-4-oxylanylmethoxy)phenyl}-4-(4-oxylanylmethoxyphenyl)-1-cyclohexene, synthetic product
      MM was prepared by referring to JP-A No. 2005-206814.

### (Additive)

- TPP: triphenylphosphine (curing accelerator, manufactured by Wako Pure Chemical Industries, Ltd.)

### (Organic Solvent)

- CHN: cyclohexanone (manufactured by Wako Pure Chemical Industries, Ltd., 1st grade)

### (Support)

- PET film: product name A31, manufactured by Teijin DuPont Film Japan Limited
- Copper foil: product name CF-T9D-SV, manufactured by FUKUDA METAL FOIL & POWDER CO., LTD., thickness: 35 µm

### <Synthesis Example>

### (Synthesis of Novolac Resin)

Under a nitrogen atmosphere, 105 g of resorcinol and 5 g of catechol as phenol compound monomers, 0.11 g of oxalic acid as a catalyst (0.1 % relative to the monomers), and 15 g of methanol as a solvent were weighed out, and added into a separable flask. Then, the content was stirred, and 30 g of formalin were added thereto while cooling the separable flask in an oil bath such that the temperature of the content was maintained at 40°C or lower. After stirring for 2 hours, the temperature of the oil bath was raised to 100°C, and water and methanol were distilled off under reduced pressure while heating. After confirming that the distilling off of water and methanol completed, CHN was added such that the content percentage of the novolac resin became 35%, thereby obtaining a solution of a catechol resorcinol novolac resin (CRN).

The number average molecular weight and the monomer content ratio were determined from a molecular weight measurement of the obtained product using GPC. Further, the NMR spectrum of the obtained product was measured, and it was confirmed that the catechol resorcinol novolac resin (CRN) included a structural unit represented by Formula (IV). The conditions for the GPC measurement and the NMR measurement are described later.

### <Example 1>

57.32 parts of a mixture of aluminum oxide particles (AA-18, AA-3 and AA-04 in a volume-based mixing ratio of 2.6:2.4:1.0), 21.12 parts of HP (in a volume-based mixing ratio of 4.0 relative to AA-04), 7.38 parts of CRN as a curing agent for epoxy resins, and 29.01 parts of CHN were mixed. After confirming that the mixture became homogeneous, 2.16 parts of TN and 6.49 parts of DN as epoxy resins, and 0.06 parts of TPP were further added thereto and mixed. Thereafter, the mixture was ground with a ball mill for from 20 hours to 40 hours, thereby obtaining a coating liquid for forming a resin layer, as a resin composition.

A PET film (A31, manufactured by Teijin DuPont Films Japan Limited, thickness: 50 µm) in which releasability had been imparted to one face thereof, was used as a support, and the coating liquid for forming a resin layer was applied, in a thickness of approximately 100 µm, to the releasability-imparted face using a TABLE COATER (manufactured by TESTER SANGYO CO., LTD.), thereby forming a coating layer. Then, drying was performed for 5 minutes in a box type oven at 100°C. In this way, a resin sheet (also referred to as an A-stage sheet) in which a resin layer in the A-stage state was formed on the PET film, was prepared.

Two sheets of the A-stage sheet obtained as described above were stacked such that the resin layers faced each other. These sheets were bonded together by performing a heating and pressurizing treatment using a hot-press apparatus (hot plate at 100°C, at a pressure of 10 MPa for a treatment time of 1 minute), whereby a resin sheet (also referred to as a B-stage sheet) in the B-stage state having an average thickness of 177 µm was obtained.

### [Preparation of Resin Sheet Laminated Body Cured Product]

The PET films were removed from both sides of the B-stage sheet obtained as described above, a copper foil (CF-T9D-SV, manufactured by FUKUDA METAL FOIL & POWDER CO., LTD.) having a thickness of 35 µm was superposed on each side, and then the resulting laminated body was subjected to a press treatment. The press treatment conditions included a hot plate temperature of 150°C, a degree of vacuum of 10 kPa or less, a pressure of 10 MPa, and a treatment time of 3 minutes. Then, heat treatments were sequentially conducted in a box type oven at 140°C for 2 hours, at 165°C for 2 hours, and at 190°C for 2 hours, whereby resin sheet laminated body cured product 1 in the C-stage state, having a copper foil disposed on both sides, was obtained.

### <Example 2>

A resin sheet in the A-stage state, a resin sheet in the B-stage state, and resin sheet laminated body cured product 2 in the C-stage state, having a copper foil disposed on both sides, were obtained in the same manner as that in Example 1, except that 7.13 parts of CRN, which is a curing agent, and 4.39 parts of TN and 4.39 parts of DN, which are epoxy resins, were used.

### <Example 3>

A resin sheet in the A-stage state, a resin sheet in the B-stage state, and resin sheet laminated body cured product 3 in the C-stage state, having a copper foil disposed on both sides, were obtained in the same manner as that in Example 1, except that 6.87 parts of CRN, which is a curing agent, and 6.68 parts of TN and 2.22 parts of DN, which are epoxy resins, were used.

### <Example 4>

A resin sheet in the A-stage state, a resin sheet in the B-stage state, and resin sheet laminated body cured product 4 in the C-stage state, having a copper foil disposed on both sides, were obtained in the same manner as that in Example 1, except that 6.77 parts of CRN, which is a curing agent, and 7.62 parts of TN and 1.34 parts of DN, which are epoxy resins, were used.

### <Example 5>

A resin sheet in the A-stage state, a resin sheet in the B-stage state, and resin sheet laminated body cured product 5 in the C-stage state, having a copper foil disposed on both sides, were obtained in the same manner as that in Example 1, except that 6.52 parts of CRN, which is a curing agent, and 2.27 parts of TN and 6.81 parts of BP, which are epoxy resins, were used.

### <Example 6>

A resin sheet in the A-stage state, a resin sheet in the B-stage state, and resin sheet laminated body cured product 6 in the C-stage state, having a copper foil disposed on both sides, were obtained in the same manner as that in Example 1, except that 6.55 parts of CRN, which is a curing agent, and 4.54 parts of TN and 4.53 parts of BP, which are epoxy resins, were used.

### <Example 7>

A resin sheet in the A-stage state, a resin sheet in the B-stage state, and resin sheet laminated body cured product 7 in the C-stage state, having a copper foil disposed on both sides, were obtained in the same manner as that in Example 1, except that 6.58 parts of CRN, which is a curing agent, and 6.79 parts of TN and 2.27 parts of BP, which are epoxy resins, were used.

### <Example 8>

A resin sheet in the A-stage state, a resin sheet in the B-stage state, and resin sheet laminated body cured product 8 in the C-stage state, having a copper foil disposed on both sides, were obtained in the same manner as that in Example 1, except that 6.74 parts of CRN, which is a curing agent, 5.72 parts of TN, 1.91 parts of BP, and 1.34 parts of DN, which are epoxy resins, and 25.92 parts of CHN were used.

### <Example 9>

A resin sheet in the A-stage state, a resin sheet in the B-stage state, and resin sheet laminated body cured product 9 in the C-stage state, having a copper foil disposed on both sides, were obtained in the same manner as that in Example 1, except that 6.59 parts of CRN, which is a curing agent, 5.77 parts of TN, 1.35 parts of BIS-A/F, and 1.93 parts of BP, which are epoxy resins, and 25.92 parts of CHN were used.

### <Example 10>

30.84 parts of a mixture of aluminum oxide particles (AA-18, AA-3 and AA-04 in a volume-based mixing ratio of 0.84:0.61:1), 66.41 parts of HP (in a volume-based mixing ratio relative to AA-04 of 9.5), 16.81 parts of CRN as a curing agent for epoxy resins, and 29.28 parts of CHN were mixed. After confirming that the mixture became homogeneous, 2.40 parts of BP, 7.60 parts of BIS-A/F, and 13.00 parts of TN as epoxy resins and 0.08 parts of TPP were further added thereto and mixed. Thereafter, the resulting mixture was ground with a ball mill for from 20 hours to 40 hours, thereby obtaining a coating liquid for forming a resin layer, as a resin composition. A resin sheet in the A-stage state, a resin sheet in the B-stage state, and resin sheet laminated body cured product 10 in the C-stage state, having a copper foil disposed on both sides, were obtained in the same manner as that in Example 1, except that this coating liquid was used.

### <Example 11>

23.97 parts of a mixture of aluminum oxide particles (AA-18,AA-3 and AA-04 in a volume-based mixing ratio of 0.84:0.61:1), 51.60 parts of HP (in a volume-based mixing ratio relative to AA-04 of 9.5), 15.10 parts of CRN as a curing agent for epoxy resins, and 31.56 parts of CHN were mixed. After confirming that the mixture became homogeneous, 2.10 parts of BP, 6.80 parts of BIS-A/F, and 11.70 parts of TN as epoxy resins and 0.08 parts of TPP were further added thereto and mixed. Thereafter, the resulting mixture was ground with a ball mill for from 20 hours to 40 hours, thereby obtaining a coating liquid for forming a resin layer, as a resin composition. A resin sheet in the A-stage state, a resin sheet in the B-stage state, and resin sheet laminated body cured product 11 in the C-stage state, having a copper foil disposed on both sides, were obtained in the same manner as that in Example 1, except that this coating liquid was used.

### <Comparative Example 1 >

57.32 parts of a mixture of aluminum oxide particles (AA-18, AA-3 and AA-04 in a volume-based mixing ratio of 0.84:0.61:1.0), 21.12 parts of HP (in a volume-based mixing ratio relative to AA-04 of 4.0), 6.50 parts of CRN as a curing agent for epoxy resin, and 34.6 parts of CHN were mixed. After confirming that the mixture became homogeneous, 9.09 parts of BP as an epoxy resin and 0.06 parts of TPP were further added thereto and mixed. Thereafter, the resulting mixture was ground with a ball mill for from 20 hours to 40 hours, thereby obtaining a coating liquid for forming a resin layer, as a resin composition.

A PET film (A31, manufactured by Teijin DuPont Films Japan Limited, thickness: 50 µm) in which releasability had been imparted to one face thereof, was used as a support, and the coating liquid for forming a resin layer was applied, in a thickness of approximately 100 µm, to the releasability-imparted face using a TABLE COATER (manufactured by TESTER SANGYO CO., LTD.), thereby forming a coating layer. Then, drying was performed for 5 minutes in a box type oven at 100°C. In this way, a resin sheet in which a resin layer in the A-stage state was formed on the PET film, was prepared.

Two sheets of the A-stage sheet obtained as described above were stacked such that the resin layers faced each other. These sheets were bonded together by performing a heating and pressurizing treatment using a hot-press apparatus (hot plate at 100°C, at a pressure of 10 MPa for a treatment time 1 minute), whereby a resin sheet (also referred to as a B-stage sheet) in the B-stage state having an average thickness of 171 µm was obtained.

### [Preparation of Resin Sheet Laminated Body Cured Product]

The PET films were removed from both sides of the B-stage sheet obtained as described above, a copper foil (CF-T9D-SV, manufactured by FUKUDA METAL FOIL & POWDER CO., LTD.) having a thickness of 35 µm was superposed on each side, and then the resulting laminated body was subjected to a press treatment. The press treatment conditions included a hot plate temperature of 150°C, a degree of vacuum of 10 kPa or less, a pressure of 10 MPa, and a treatment time of 3 minutes. Then, heat treatments were sequentially conducted in a box type oven at 140°C for 2 hours, at 165°C for 2 hours, and at 190°C for 2 hours, whereby resin sheet laminated body cured product C 1 in the C-stage state, having a copper foil disposed on both sides, was obtained.

### <Comparative Example 2>

A resin sheet in the A-stage state, a resin sheet in the B-stage state, and resin sheet laminated body cured product C2 in the C-stage state, having a copper foil disposed on both sides, were obtained in the same manner as that in Comparative Example 1, except that 6.61 parts of CRN, which is a curing agent, and 9.04 parts of TN, which is an epoxy resin, were used.

### <Comparative Example 3>

A resin sheet in the A-stage state, a resin sheet in the B-stage state, and resin sheet laminated body cured product C3 in the C-stage state, having a copper foil disposed on both sides, were obtained in the same manner as that in Comparative Example 1, except that 5.83 parts of CRN, which is a curing agent, and 9.43 parts of MM, which is an epoxy resin, were used.

### <Comparative Example 4>

A resin sheet in the A-stage state, a resin sheet in the B-stage state, and resin sheet laminated body cured product C4 in the C-stage state, having a copper foil disposed on both sides, were obtained in the same manner as that in Comparative Example 1, except that 6.69 parts of CRN, which is a curing agent, 29.01 parts of CHN, and 9.00 parts of TPM, which is an epoxy resin, were used.

### <Comparative Example 5>

A resin sheet in the A-stage state, a resin sheet in the B-stage state, and resin sheet laminated body cured product C5 in the C-stage state, having a copper foil disposed on both sides, were obtained in the same manner as that in Comparative Example 1, except that 6.67 parts of CRN, which is a curing agent, 29.01 parts of CHN, and 4.50 parts of TPM and 4.50 parts of BIS-A/F, which are epoxy resins, were used.

### <Comparative Example 6>

A resin sheet in the A-stage state, a resin sheet in the B-stage state, and resin sheet laminated body cured product C6 in the C-stage state, having a copper foil disposed on both sides, were obtained in the same manner as that in Comparative Example 1, except that 6.52 parts of CRN, which is a curing agent, 29.01 parts of CHN, and 6.81 parts of TN and 2.27 parts of BIS-A/F, which are epoxy resins, were used.

### <Comparative Example 7>

A resin sheet in the A-stage state, a resin sheet in the B-stage state, and resin sheet laminated body cured product C7 in the C-stage state, having a copper foil disposed on both sides, were obtained in the same manner as that in Comparative Example 1, except that 6.55 parts of CRN, which is a curing agent, 29.01 parts of CHN, and 4.53 parts of TN and 4.53 parts of BIS-A/F, which are epoxy resins, were used.

### <Comparative Example 8>

A resin sheet in the A-stage state, a resin sheet in the B-stage state, and resin sheet laminated body cured product C8 in the C-stage state, having a copper foil disposed on both sides, were obtained in the same manner as that in Comparative Example 1, except that 6.58 parts of CRN, which is a curing agent, 29.01 parts of CHN, and 2.27 parts of TN and 6.79 parts of BIS-A/F, which are epoxy resins, were used.

### [Evaluation]

The following evaluations were carried out on the CRN, the resin sheets in the A-stage state, the resin sheets in the B-stage state, and the resin sheet laminated body cured products in the C-stage state obtained above. The evaluation results are indicated in Table 1 and Table 2. In Table 1 and Table 2, the unit for the numerical values for the resin composition is parts by mass.

### (GPC Measurement)

The CRN obtained in the above synthesis example was dissolved in tetrahydrofran (for liquid chromatography), and passed through a filter made of PTFE (CHROMATODISK, model number: 13N, manufactured by Kurabo Industries Ltd., for HPLC pretreatment, pore diameter: 0.45 µm) to remove insoluble matters. The number average molecular weight was measured using a GPC [pump: L6200 PUMP (manufactured by Hitachi, Ltd.), detector: differential refractive index detector L3300 RI MONITOR (manufactured by Hitachi, Ltd.), column: TSK GEL-G5000HXL and TSK GEL-G2000HXL (two columns in total) (both manufactured by Tosoh Corporation) connected in series, column temperature: 30°C, eluent: tetrahydrofuran, flow rate: 1.0 mL/min, standard reference material: polystyrene].

### (NMR Measurement)

The CRN obtained in the synthesis example described above was dissolved in deuterated dimethyl sulfoxide (DMSO-d₆), and ¹H-NMR spectrum was measured using a proton nuclear magnetic resonance method (¹H-NMR) (AV-300 (300 MHz), manufactured by BRUKER Corporation). Regarding the chemical shift standard, tetramethylsilane as an internal standard material was taken as 0 ppm.

### (Thermal Conductivity Coefficient of Resin Sheet Laminated Body Cured Product)

From the resin sheet laminated body cured product in the C-stage state obtained in the above experiment, the copper foils were removed by etching using a sodium peroxosulfate solution. The remaining material was cut into a 10 mm square piece, this piece was subjected to a blackening treatment with a graphite spray, and then thermal diffusivity was measured using a NANOFLASH model LFA447, manufactured by NETZSCH Geraetebau GmbH.

The measurement conditions included a measurement temperature of 25°C ± 1°C, a measurement voltage of 270 V, an amplitude of 5000, and a pulse width of 0.06 ms.

The thermal conductivity coefficient was calculated from the product of the obtained thermal diffusivity, the density obtained by the Archimedes' method, and the specific heat measured using a DSC (differential calorimeter).

### (Glass Transition Temperature)

From the resin sheet laminated body cured product in the C-stage state obtained in the above experiment, the copper foils were removed by etching using a sodium peroxosulfate solution. The remaining material was cut into a 30 mm × 5 mm piece, and the temperature dependencies of storage elastic modulus and loss elastic modulus were measured using an RHEO SPECTOLER manufactured by UBM. The "tan δ" is defined as a value obtained by dividing the storage elastic modulus by the loss elastic modulus, and the temperature at which this value reaches its peak is designated as the glass transition temperature. The measurement conditions included a temperature elevating rate of 3°C/min, a measurement temperature of from 30°C to 300°C, a frequency of 10 Hz, a span distance of 20 mm, a distortion of 1 µm, and in atmosphere.

### (Peel Strength)

After removing the PET films from both sides of the B-stage sheet having a size of 100 mm × 100 mm × 0.2 mm, a copper foil having a size of 100 mm × 100 mm × 0.035 mm was disposed on both sides, and bonded by pressing. The resulting laminated body was subjected to a curing treatment to get into the C-stage state. The resultant was cut into a 100 mm × 25 mm piece, one face thereof was protected with a tape, and the copper foil on the other side was removed by an etching treatment, to form a copper pattern of 100 mm × 10 mm. The peel strength of the copper foil was measured by pulling the copper pattern using a model AGC-100, manufactured by Shimadzu Corporation under the conditions of a test speed of 50 mm/min and a measurement temperature of 23°C (for peel strength), 150°C (for 150°C peel strength), or 180°C (for 180°C peel strength). For each sample, the measurement was conducted three times, and the average value thereof was taken as the peel strength.

In the above, the bonding and the curing treatment was performed as follows. Copper plates were bonded by performing vacuum hot press (hot plate temperature: 120°C, degree of vacuum: 1 kPa or less, pressure: 10 MPa, treatment time: 3 minutes), and, thereafter, a stepwise curing treatment was performed in a box type oven at 140°C for 2 hours, at 165°C for 2 hours, and at 190°C for 2 hours.

### (Average Thickness of B-Stage Sheet)

The average thickness of the B-stage sheet was measured as follows. The B-stage sheet was cut into a 100 mm square piece still having the support, and its thickness was measured at 9 positions using a MICROMETER IP65, manufactured by Mitutoyo Corporation. Assuming that the thicknesses of the PET film and the aluminum foil serving as supports do not change during conversion to the B-stage, the thicknesses of the resin layer at the 9 positions were determined by subtracting the thickness of the support, and the arithmetic mean value thereof was taken as the average thickness of the B-stage sheet.

### (Average Thickness of Resin Sheet Cured Body)

From the resin sheet laminated body cured product in the C-stage state obtained above, the copper foils were removed by etching using a sodium peroxosulfate solution. In this way, a resin sheet cured body was obtained. The resin sheet cured body was cut into a 100 mm square piece, and its thickness was measured at 9 positions using a MICROMETER IP65, manufactured by Mitutoyo Corporation. The arithmetic mean value thereof was taken as the average thickness of the resin sheet cured body.

### (Flexibility of B-Stage Sheet)

The B-stage sheet cut into a 50 mm × 10 mm piece was pressed against a circular cylinder having a diameter of 10 mm, and the presence or absence of cracks in the sheet was judged visually and evaluated as flexibility. The test temperature was set at 20°C ± 3°C, and the test was carried out 5 times at respectively different positions. The evaluation criteria are as follows.
A: The number of positions at which cracking was not observed is two or more.
B: The number of positions at which cracking was not observed is one or fewer.

**TABLE 1**

| Item | | | Examples | | | | | | | | | | |
|---|---|---|---|---|---|---|---|---|---|---|---|---|---|
| No. | | | 1 | 2 | 3 | 4 | 5 | 6 | 7 | 8 | 9 | 10 | 11 |
| Weight Ratio | Filler | AA-04 | 9.55 | 9.55 | 9.55 | 9.55 | 9.55 | 9.55 | 9.55 | 9.55 | 9.55 | 12.62 | 9.81 |
| | | AA-3 | 22.93 | 22.93 | 22.93 | 22.93 | 22.93 | 22.93 | 22.93 | 22.93 | 22.93 | 7.66 | 5.95 |
| | | AA-18 | 24.84 | 24.84 | 24.84 | 24.84 | 24.84 | 24.84 | 24.84 | 24.84 | 24.84 | 10.56 | 8.21 |
| | | HP | 21.12 | 21.12 | 21.12 | 21.12 | 21.12 | 21.12 | 21.12 | 21.12 | 21.12 | 66.41 | 51.60 |
| | Epoxy Resin | TN | 2.16 | 4.39 | 6.68 | 7.62 | 2.27 | 4.54 | 6.79 | 5.72 | 5.77 | 13.00 | 11.70 |
| | | DN | 6.49 | 4.39 | 2.22 | 1.34 | - | - | - | 1.34 | - | - | - |
| | | BP | - | - | - | - | 6.81 | 4.53 | 2.27 | 1.91 | 1.93 | 2.40 | 2.10 |
| | | BIS-A/F | - | - | - | - | - | - | - | - | 1.35 | 7.60 | 6.80 |
| | | TPM | - | - | - | - | - | - | - | - | - | - | - |
| | | MM | - | - | - | - | - | - | - | - | - | - | - |
| | Curing Agent Catalyst | CRN | 7.38 | 7.13 | 6.87 | 6.77 | 6.52 | 6.55 | 6.58 | 6.74 | 6.59 | 16.81 | 15.10 |
| | | TPP | 0.06 | 0.06 | 0.06 | 0.06 | 0.06 | 0.06 | 0.06 | 0.06 | 0.06 | 0.08 | 0.08 |
| | Solvent | CHN | 29.01 | 29.01 | 29.01 | 29.01 | 29.01 | 29.01 | 29.01 | 25.92 | 25.92 | 29.28 | 31.56 |
| A-Stage | Substrate to be Coated | - | PET | PET | PET | PET | PET | PET | PET | PET | PET | PET | PET |
| B-Stage | Thickness | µm | 177 | 181 | 180 | 182 | 156 | 164 | 159 | 178 | 174 | 175 | 168 |
| | Flexibility | | A | A | A | A | A | A | A | A | A | A | A |
| C-Stage | Thickness | µm | 161 | 165 | 164 | 166 | 142 | 148 | 145 | 164 | 159 | 164 | 161 |
| | Thermal Conductivity Coefficient | W/mK | 13.1 | 12.5 | 12.2 | 11.7 | 13.5 | 11.5 | 11.2 | 9.5 | 10.2 | 11.2 | 10.9 |
| | Peel Strength | kN/m | 0.62 | 0.70 | 0.71 | 0.65 | 0.65 | 0.67 | 0.66 | 0.69 | 0.71 | 0.61 | 0.59 |
| | 150°C Peel Strength | kN/m | 0.44 | 0.50 | 0.54 | 0.49 | 0.50 | 0.52 | 0.55 | 0.57 | 0.54 | 0.48 | 0.47 |
| | 180°C Peel Strength | kN/m | 0.40 | 0.40 | 0.39 | 0.38 | 0.36 | 0.41 | 0.40 | 0.54 | 0.51 | 0.42 | 0.39 |
| | Glass Transition Temperature | °C | 205 | 218 | 224 | 235 | 191 | 226 | 255 | 240 | 223 | 219 | 215 |

**TABLE 2**

| Item | | | Comparative Examples | | | | | | | |
|---|---|---|---|---|---|---|---|---|---|---|
| No. | | | 1 | 2 | 3 | 4 | 5 | 6 | 7 | 8 |
| Mass Ratio | Filler | AA-04 | 9.55 | 9.55 | 9.55 | 9.55 | 9.55 | 9.55 | 9.55 | 9.55 |
| | | AA-3 | 22.93 | 22.93 | 22.93 | 22.93 | 22.93 | 22.93 | 22.93 | 22.93 |
| | | AA-18 | 24.84 | 24.84 | 24.84 | 24.84 | 24.84 | 24.84 | 24.84 | 24.84 |
| | | HP | 21.12 | 21.12 | 21.12 | 21.12 | 21.12 | 21.12 | 21.12 | 21.12 |
| | Epoxy Resin | TN | - | 9.04 | - | - | - | 6.81 | 4.53 | 2.27 |
| | | DN | - | - | - | - | - | - | - | - |
| | | BP | 9.09 | - | - | - | - | - | - | - |
| | | BIS-A/F | - | - | - | - | 4.50 | 2.27 | 4.53 | 6.79 |
| | | TPM | - | - | - | 9.00 | 4.50 | - | - | - |
| | | MM | - | - | 9.43 | - | - | - | - | - |
| | Curing Agent | CRN | 6.50 | 6.61 | 5.83 | 6.69 | 6.67 | 6.52 | 6.55 | 6.58 |
| | Curing Accelerator | TPP | 0.06 | 0.06 | 0.06 | 0.06 | 0.06 | 0.06 | 0.06 | 0.06 |
| | Solvent | CHN | 34.6 | 34.6 | 34.6 | 29.01 | 29.01 | 29.01 | 29.01 | 29.01 |
| A-Stage | Substrate to be Coated | - | PET | PET | PET | PET | PET | PET | PET | PET |
| B-Stage | Thickness | µm | 171 | 165 | 172 | 168 | 166 | 168 | 177 | 180 |
| | Flexibility | | B | B | B | B | A | B | A | A |
| C-Stage | Thickness | µm | 161 | 160 | 168 | 157 | 155 | 164 | 165 | 167 |
| | Thermal Conductivity Coefficient | W/mK | 7.1 | 8.6 | 11.2 | 8.4 | 7.8 | 7.2 | 6.5 | 6.0 |
| | Peel Strength | kN/m | 0.60 | 0.48 | 0.61 | 0.35 | 0.41 | 0.65 | 0.72 | 0.75 |
| | 150°C Peel Strength | kN/m | 0.38 | 0.39 | 0.28 | 0.17 | 0.21 | 0.50 | 0.42 | 0.38 |
| | 180°C Peel Strength | kN/m | 0.32 | 0.32 | 0.15 | 0.12 | 0.14 | 0.43 | 0.31 | 0.29 |
| | Glass Transition Temperature | °C | 168 | 248 | 175 | 240 | 160 | 206 | 181 | 167 |

In Table 1 and Table 2, the "-" means that the indicated component is not contained.

It is understood from Table 1 and Table 2 that the resin composition that includes an epoxy resin represented by Formula (I), at least one selected from the group consisting of an epoxy resin represented by Formula (II) and an epoxy resin represented by Formula (III), and the specific novolac resin, the resin sheet in the B-stage state formed from the resin composition, and the resin sheet cured body in the C-stage state, which is a cured product of the resin sheet, each have both of excellent thermal conductivity and excellent adhesive property.

The disclosure of Japanese Patent Application No. 2014-058833 is incorporated by reference herein in its entirety. All publications, patent applications, and technical standards mentioned in this specification are herein incorporated by reference to the same extent as if such individual publication, patent application, or technical standard was specifically and individually indicated to be incorporated by reference.

### Explanation of Reference Numerals

100: Power Semiconductor instrument, 102: Resin sheet cured body, 103: Housing, 104: Copper Plate, 106: Heat Radiation Base, 108: Grease Layer, 110: Power Semiconductor device, 120: Water Cooling Jacket, 150: Power Semiconductor instrument, 200: Power Semiconductor instrument, 250: Power Semiconductor instrument, 300: Power Semiconductor instrument, 350: Power Semiconductor instrument, 130: LED Chip, 132: Resin sheet cured body, 134: Aluminum Substrate, 136: Grease Layer, 138: Housing, 140: Screw, 142: Circuit Layer, 146: Sealing Resin, 148: Power Source Member

## Claims

1. A resin composition comprising:
a trifunctional or higher-functional first epoxy resin having, in a molecule thereof, a structure including two naphthalene rings linked together by an alkylene chain;
a bifunctional second epoxy resin having a mesogenic structure in a molecule thereof; and
a curing agent.

2. The resin composition according to claim 1, wherein the first epoxy resin comprises a compound represented by the following Formula (I): 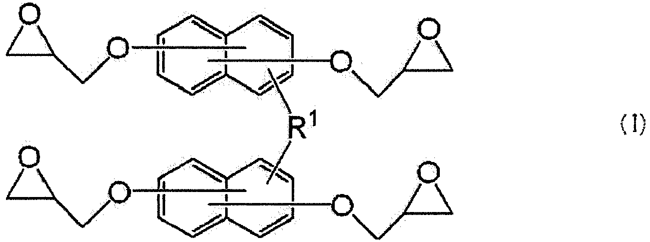 wherein, in Formula (I), R¹ represents an alkylene group having from 1 to 7 carbon atoms.

3. The resin composition according to claim 1 or claim 2, wherein the second epoxy resin comprises at least one selected from the group consisting of a compound represented by the following Formula (II) and a compound represented by the following Formula (III): 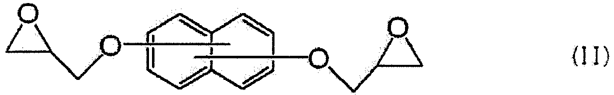 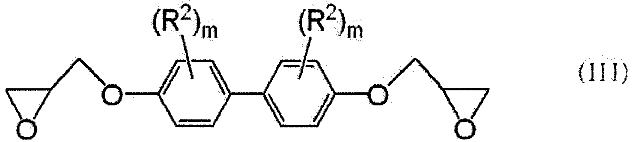 wherein, in Formula (III), each R² independently represents an alkyl group, an aryl group, or an aralkyl group, and each m independently represents an integer from 0 to 2.

4. The resin composition according to any one of claim 1 to claim 3, wherein a content ratio by mass of the first epoxy resin to the second epoxy resin (first epoxy resin : second epoxy resin) is from 25:75 to 85:15.

5. The resin composition according to any one of claim 1 to claim 4, wherein the curing agent comprises a novolac resin including a structural unit represented by the following Formula (IV): 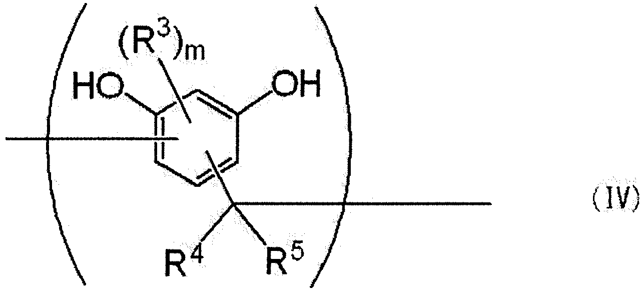 wherein, in Formula (IV), each R³ independently represents an alkyl group, an aryl group, or an aralkyl group, each of R⁴ and R⁵ independently represents a hydrogen atom, an alkyl group, an aryl group, or an aralkyl group, and m represents an integer from 0 to 2.

6. The resin composition according to any one of claim 1 to claim 5, further comprising, as fillers, boron nitride particles having a volume average particle diameter of from 20 µm to 80 µm and inorganic particles having a volume average particle diameter of 1 µm or less.

7. A resin sheet comprising the resin composition of any one of claim 1 to claim 6, the resin sheet having an average thickness of from 40 µm to 250 µm.

8. The resin sheet according to claim 7, wherein the resin sheet is bendable along an outer circumferential face of a circular cylinder having a diameter of 10 mm when the resin sheet is in a B-stage state.

9. The resin sheet according to claim 7 or claim 8, wherein the resin sheet includes a first resin layer including the resin composition of any one of claim 1 to claim 6, and a second resin layer including the resin composition of any one of claim 1 to claim 6, the second resin layer being layered on the first resin layer.

10. The resin sheet according to any one of claim 7 to claim 9, further including a metal foil on one face, and a plastic film on an opposite face from the face having the metal foil.

11. A resin sheet cured body that is a heat-treated product of the resin sheet of any one of claim 7 to claim 10.

12. A resin sheet laminated body comprising the resin sheet of any one of claim 7 to claim 9, and a metal plate or heat radiation plate disposed on at least one face of the resin sheet.

13. The resin sheet laminated body according to claim 12, further comprising a member attached to an opposite face of the resin sheet from the face at which the metal plate or heat radiation plate is disposed.

14. A resin sheet laminated body cured product that is a heat-treated product of the resin sheet laminated body of claim 12 or claim 13.

15. A method of producing a resin sheet laminated body cured product, the method comprising:
a process of providing a metal plate or a heat radiation plate on at least one face of the resin sheet of any one of claim 7 to claim 9, and
a process of applying heat to the resin sheet, thereby curing the resin sheet.

16. A semiconductor instrument comprising:
a semiconductor device, and
the resin sheet cured body of claim 11 disposed on the semiconductor device.

17. An LED instrument comprising an LED device, the resin sheet cured body of claim 11, and a substrate, which are stacked in this order.
